(19) Europäisches Patentamt
European Patent Office
Office européen des brevets

(11) **EP 4 345 902 A1**

(12) **EUROPEAN PATENT APPLICATION**

(43) Date of publication:
**03.04.2024 Bulletin 2024/14**

(21) Application number: **23194011.5**

(22) Date of filing: **29.08.2023**

(51) International Patent Classification (IPC):
***H01L 27/146*** (2006.01)

(52) Cooperative Patent Classification (CPC):
**H01L 27/14627; H01L 27/14605;** H01L 27/14645

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **02.09.2022 KR 20220111689**

(71) Applicant: **Samsung Electronics Co., Ltd.**
**Suwon-si, Gyeonggi-do 16677 (KR)**

(72) Inventors:
• **AHN, Sungmo**
**16678 Suwon-si (KR)**
• **MUN, Sangeun**
**16678 Suwon-si (KR)**

• **CHO, Choonlae**
**16678 Suwon-si (KR)**
• **ROH, Sookyoung**
**16678 Suwon-si (KR)**
• **PARK, Hyunsung**
**16678 Suwon-si (KR)**
• **YUN, Seokho**
**16678 Suwon-si (KR)**
• **LEE, Sangyun**
**16678 Suwon-si (KR)**
• **LEE, Junho**
**16678 Suwon-si (KR)**

(74) Representative: **Elkington and Fife LLP**
**Prospect House**
**8 Pembroke Road**
**Sevenoaks, Kent TN13 1XR (GB)**

(54) **IMAGE SENSOR AND ELECTRONIC APPARATUS INCLUDING THE SAME**

(57) An image sensor includes a sensor substrate including a plurality of unit pixel groups each including a first pixel, a second pixel, a third pixel, and a fourth pixel arranged in a Bayer pattern, and a color separating lens array which separates incident light according to wavelengths and condenses the light on each of the first to fourth pixels, wherein the color separating lens array a plurality of pixel corresponding groups respectively corresponding to the plurality of unit pixel groups, and the plurality of pixel corresponding groups each include first to fourth pixel corresponding regions corresponding to the first to fourth pixels and a plurality of nanoposts. From among the plurality of pixel corresponding groups, relative positional relationships between the nanoposts of the first to fourth pixel corresponding regions in each of the plurality of peripheral groups that are located out of the center of the color separating lens array may be different from each other.

FIG. 2A

EP 4 345 902 A1

# Description

## FIELD OF THE INVENTION

The disclosure relates to an image sensor and an electronic apparatus including the same.

## BACKGROUND OF THE INVENTION

Image sensors generally sense the color of incident light by using a color filter. However, a color filter may have low light utilization efficiency because the color filter absorbs light of colors other than the intended color of light. For example, in the case of a red-green-blue (RGB) color filter is used, only 1/3 of the incident light is transmitted therethrough and the other part of the incident light, that is, 2/3 of the incident light, is absorbed. Thus, the light utilization efficiency is only about 33%, and most of the light loss in the image sensor occurs in a color filter. Accordingly, a method of separating colors by using each pixel in an image sensor without using a color filter has been attempted.

## SUMMARY OF THE INVENTION

Provided is an image sensor including a color separation lens array capable of separating incident light according to wavelengths and condensing separated light.

Provided is an image sensor including a color separation lens array having less performance variation according to a chief ray angle.

Additional aspects will be set forth in part in the description which follows and, in part, will be apparent from the description, or may be learned by practice of the presented embodiments of the disclosure.

According to an aspect of the disclosure, there is provided an image sensor including: a sensor substrate including a plurality of pixel unit groups, each of the plurality of pixel unit groups including a first pixel, a second pixel, a third pixel, and a fourth pixel arranged in a Bayer pattern; and a color separating lens array configured to separate incident light according to wavelengths and condense the light onto each of the first pixel, the second pixel, the third pixel and the fourth pixel, wherein the color separating lens array incudes a plurality of pixel corresponding groups respectively corresponding to the plurality of unit pixel groups, each of the plurality of pixel corresponding groups including a first pixel corresponding region corresponding to the first pixel, a second pixel corresponding region corresponding to the second pixel, a third pixel corresponding region corresponding to the third pixel, and a fourth pixel corresponding region corresponding to the fourth pixel, and each of the first pixel corresponding region, the second pixel corresponding region, the third pixel corresponding region and the fourth pixel corresponding region including a plurality of nanoposts, wherein the plurality of pixel corresponding groups including a central group located at a center of the color separating lens array and a plurality of peripheral groups located away from the center of the color separating lens array, and wherein relative positional relationships among the nanoposts in the first pixel corresponding region, the second pixel corresponding region, the third pixel corresponding region and the fourth pixel corresponding region in each of the plurality of peripheral groups are different from each other.

Each of the first pixel, the second pixel, the third pixel and the fourth pixel may include four photosensitive cells arranged in a 2x2 array.

The relative positional relationships among the nanoposts for each of the plurality of pixel corresponding groups is configured according to a chief ray angle and an azimuth that are defined according to a position of the peripheral group on the image sensor.

The fourth pixel may be adjacent to the third pixel in a first direction, the first pixel may be adjacent to the third pixel in a second direction that is perpendicular to the first direction, the second pixel may be adjacent to the third pixel in a diagonal direction, and the third pixel may be a red pixel, the first pixel and the fourth pixel may be green pixels, and the second pixel may be a blue pixel.

Based on the relative positional relationships between the nanoposts of the first pixel corresponding region, the second pixel corresponding region, the third pixel corresponding region and the fourth pixel corresponding region in the central group, one or more of the nanoposts in the first pixel corresponding region, the second pixel corresponding region, the third pixel corresponding region and the fourth pixel corresponding region are shifted in the peripheral group with respect to the central group.

The one or more of the nanoposts of the first pixel corresponding region in the peripheral group are shifted in the second direction, wherein a shifted displacement of the one or more of the nanoposts of the first pixel corresponding region is proportional to $(CRA/CRA\_max) * \sin\varphi$, and wherein CRA_max denotes a maximum value of a chief ray angle of light incident on the color separating lens array, CRA denotes a chief ray angle at a position of the one or more shifted nanopost, and $\varphi$ denotes an azimuth at the position of the one or more shifted nanopost based on an axis that passes through the center of the color separating lens array and is in parallel with the first direction.

The one or more nanoposts of the fourth pixel corresponding region in the peripheral group are shifted in the first direction, wherein a shifted displacement of the fourth pixel corresponding region is proportional to $(CRA/CRA\_max) * \cos\varphi$, where CRA_max denotes a maximum value of a chief ray angle of light incident on the color separating lens array, CRA denotes a chief ray angle at a position of the one or more shifted nanopost, and $\varphi$ denotes an azimuth at the position of the one or more shifted nanopost based on an axis that passes through the center of the color separating lens array and is in parallel with the first direction.

The one or more nanoposts of the second pixel corresponding region in the peripheral group are shifted in the first direction and the second direction, wherein a shifted displacement of the one or more nanoposts of the second color separating lens in the first direction is proportional to (CRA/CRA_max) * cosφ, wherein a shifted displacement one or more nanoposts of the second color separating lens in the second direction is proportional to (CRA/CRA_max) * sinφ, and wherein CRA_max denotes a maximum value of a chief ray angle of light incident on the color separating lens array, CRA denotes a chief ray angle at a position of the one or more shifted nanopost, and φ denotes an azimuth at the position of the one or more shifted nanopost based on an axis that passes through the center of the color separating lens array and is in parallel with the first direction.

One or more nanoposts located at a boundary between different pixel corresponding regions from among the first pixel corresponding region, the second pixel corresponding region, the third pixel corresponding region and the fourth pixel corresponding region in the peripheral group are shifted by an average displacement of the nanoposts in adjacent pixel corresponding regions.

According to another aspect of the disclosure, there is provided an image sensor including: a sensor substrate including a plurality of unit pixel groups, each of the plurality of unit pixel groups having a red pixel, a first green pixel adjacent to the red pixel in a Y direction, a second green pixel adjacent to the red pixel in an X direction, and a blue pixel adjacent to the second green pixel in the Y direction; and a color separating lens array configured to separate incident light according to wavelengths and condense the light onto each of the first pixel, the second pixel, the third pixel and the fourth pixel, wherein the color separating lens array includes a plurality of pixel corresponding groups including a red pixel corresponding region, a first green pixel corresponding region, a second green pixel corresponding region, and a blue pixel corresponding region corresponding respectively to the unit pixel groups, and each of the pixel corresponding regions including a plurality of nanoposts, wherein the plurality of pixel corresponding groups include a central group located at a center of the color separating lens array and a plurality of peripheral groups located away from the center of the color separating lens array, and wherein, in peripheral groups from among plurality of peripheral groups, having an identical chief ray angle (CRA), one or more nanoposts arranged in the first green pixel corresponding region of a first peripheral group having an azimuth of 90° with respect to the central group in the X direction are shifted in +Y direction as compared with one or more nanoposts arranged in the first green pixel corresponding region of a second peripheral group having an azimuth of 45° based on the X direction.

In the peripheral groups having the identical CRA, one or more nanoposts arranged in the second green pixel corresponding region of a third peripheral group having an azimuth of 0° with respect to the central group in the X direction are shifted in +X direction as compared with one or more nanoposts arranged in the second green pixel corresponding region of a fourth peripheral group having an azimuth of 45° based on the +X direction.

In the peripheral groups having the identical CRA, one or more nanoposts arranged in the blue pixel corresponding region of a fifth peripheral group having an azimuth of 45° with respect to the central group based on the X direction are: shifted in +X direction in the fifth peripheral group as compared with one or more nanoposts arranged in the blue pixel corresponding region of a sixth peripheral group having an azimuth of 90° based on the X direction, and shifted in +Y direction in the fifth peripheral group as compared with one or more nanoposts arranged in the blue pixel corresponding region of a seventh peripheral group having an azimuth of 0° based on the X direction.

In the plurality of peripheral groups, one or more nanoposts arranged in the first green pixel corresponding region of an eighth peripheral group having an azimuth of 90° with respect to the central group based on the X direction and having a first CRA are shifted in +Y direction in the eight peripheral group, as compared with one or more nanoposts arranged in the first green pixel corresponding region of a ninth peripheral group having an azimuth of 90° based on the X direction and having a second CRA that is less than the first chief ray angle

In the plurality of peripheral groups, one or more nanoposts arranged in the first green pixel corresponding region of a tenth peripheral group having an azimuth of 0° with respect to the central group based on the X direction and having the first CRA are shifted in +X direction in the tenth peripheral group, as compared with one or more nanoposts arranged in the second green pixel corresponding region of a eleventh peripheral group having an azimuth of 0° based on the X direction and having the second CRA that is less than the first chief ray angle

In the plurality of peripheral groups, one or more nanoposts arranged in the blue pixel corresponding region of a twelfth peripheral group having an azimuth of 45° with respect to the central group based on the X direction and having the first CRA are shifted in a direction away from the central group in the corresponding peripheral group, as compared with one or more nanoposts arranged in the blue pixel corresponding region of a thirteenth peripheral group having an azimuth of 45° based on the X direction and having the second CRA that is less than the first CRA

.According to another aspect of the disclosure, there is provided an image sensor including: a sensor substrate including a plurality of pixel unit groups, each of the plurality of pixel unit groups including a first pixel, a second pixel, a third pixel, and a fourth pixel arranged in a Bayer pattern; and a color separating lens array configured to separate incident light according to wavelengths and condense the light onto each of the first pixel, the second pixel, the third pixel and the fourth pixel, wherein the color separating lens array includes a plurality of pixel corresponding groups respectively corresponding to the plurality of unit pixel groups, each of the plurality of pixel corresponding groups including a first pixel corresponding region corresponding to the first pixel, a second pixel corresponding region corresponding to the second pixel, a third pixel corresponding region corresponding to the third pixel, and a fourth pixel corresponding region corresponding to the fourth pixel, and each of the first pixel corresponding region, the second pixel corresponding region, the third pixel corresponding region and the fourth pixel corresponding region including a plurality of nanoposts, wherein the plurality of pixel corresponding groups including a central group located at a center of the color separating lens array and a plurality of peripheral groups located away from the center of the color separating lens array, and wherein an amount of variation in position of the nanoposts in the first pixel corresponding region, the second pixel corresponding region, the third pixel corresponding region and the fourth pixel corresponding region of the peripheral group with respect to the central group are different from each other.

The amount of variation in position is based on a chief ray angle and an azimuth according to a position of the peripheral group in the color separating lens array, and the amount of variation in position includes a shifted distance and a shifted direction of the nanoposts in each region toward the central group.

According to another aspect of the disclosure, there is provided an electronic apparatus including: a lens assembly including one or more lenses and configured to form an optical image of an object; an image sensor configured to convert the optical image formed by the lens assembly into an electrical signal; and a processor configured to process a signal generated by the image sensor, wherein the image sensor includes: a sensor substrate including a plurality of pixel unit groups, each of the plurality of pixel unit groups including a first pixel, a second pixel, a third pixel, and a fourth pixel arranged in a Bayer pattern; and a color separating lens array configured to separate incident light according to wavelengths and condense the light onto each of the first pixel, the second pixel, the third pixel and the fourth pixel, wherein the color separating lens array includes a plurality of pixel corresponding groups respectively corresponding to the plurality of unit pixel groups, each of the plurality of pixel corresponding groups including a first pixel corresponding region corresponding to the first pixel, a second pixel corresponding region corresponding to the second pixel, a third pixel corresponding region corresponding to the third pixel, and a fourth pixel corresponding region corresponding to the fourth pixel, and each of the first pixel corresponding region, the second pixel corresponding region, the third pixel corresponding region and the fourth pixel corresponding region including a plurality of nanoposts, wherein the plurality of pixel corresponding groups including a central group located at a center of the color separating lens array and a plurality of peripheral groups located away from the center of the color separating lens array, and wherein relative positional relationships among the nanoposts in the first pixel corresponding region, the second pixel corresponding region, the third pixel corresponding region and the fourth pixel corresponding region in each of the plurality of peripheral groups are different from each other.

BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 is a block diagram of an image sensor according to an example embodiment;
FIGS. 2A and 2B are conceptual diagrams showing a schematic structure and operations of a color separating lens array included in an image sensor according to an example embodiment;
FIG. 3A is a plan view showing a color arrangement of a pixel array in an image sensor according to an example embodiment; FIG. 3B and FIG. 3C are plan views showing a sensor substrate 110 and the color separating lens array included in the pixel array of the image sensor according to the example embodiment;
FIGS. 4A and 4B are cross-sectional views, seen from different cross-sections, of a pixel array in an image sensor according to an example embodiment;
FIG. 5A is a diagram showing phase profiles of green light and blue light that have passed through a color separating lens array on a cross-section of FIG. 4A;
FIGS. 5B and 5C are diagrams respectively showing examples of a proceeding direction of green light incident on a first green light condensing region and an array of the first green light condensing region;
FIGS. 5D and 5E are diagrams respectively showing examples of a proceeding direction of blue light incident to a blue light condensing region and an array of the blue light condensing region;
FIG. 6A is a diagram showing phase profiles of red light and green light that have passed through a color separating lens array on a cross-section of FIG. 4B;
FIGS. 6B and 6C are diagrams respectively showing examples of a proceeding direction of red light incident on a red light condensing region and an array of the red light condensing region;
FIGS. 6D and 6E are diagrams respectively showing examples of a proceeding direction of green light incident to a second green light condensing region and an array of the second green light condensing region;
FIG. 7 is a plan view for defining pixel corresponding groups of a color separating lens array in an image sensor according to an example embodiment as a central group and peripheral group according to positions thereof, and for describing an azimuth direction;

FIG. 8 is a plan view for describing positions of nanoposts included in pixel corresponding regions of a peripheral group as compared with the central group, in a color separating lens array of an image sensor according to an example embodiment;

FIG. 9 is a plan view showing an example of nanoposts included in a pixel corresponding region of a central group in a color separating lens array of an image sensor according to an example embodiment;

FIG. 10 is a plan view showing an example of nanoposts included in a pixel corresponding region of a peripheral group at a position having an azimuth of 0° in a color separating lens array of an image sensor according to an example embodiment;

FIG. 11 is a plan view showing an example of nanoposts included in a pixel corresponding region of a peripheral group at a position having an azimuth of 45° in a color separating lens array of an image sensor according to an example embodiment;

FIG. 12 is a plan view showing an example of nanoposts included in a pixel corresponding region of a peripheral group at a position having an azimuth of 90° in a color separating lens array of an image sensor according to an example embodiment;

FIG. 13 is a plan view showing arrangement of nanoposts included in pixel corresponding regions of a plurality of peripheral groups as compared with the central group, in a color separating lens array of an image sensor according to an example embodiment;

FIG. 14 is a conceptual diagram for describing arrangement relationship between a unit pixel group included in a sensor substrate and a pixel corresponding group of a color separating lens array corresponding to the unit pixel group, in an image sensor according to an example embodiment;

FIG. 15 is a conceptual diagram for describing arrangement relationship between a unit pixel group included in a sensor substrate and nanoposts included in a pixel corresponding group of a color separating lens array corresponding to the unit pixel group, in an image sensor according to an example embodiment;

FIG. 16 is a conceptual diagram showing examples of shapes of nanoposts in a central group and a few peripheral groups, which may be applied to a color separating lens array of an image sensor according to an example embodiment;

FIG. 17 is a graph showing an example of a channel difference occurring in an image sensor according to a comparative example;

FIG. 18 is a graph showing an example of a channel difference occurring in an image sensor according to an example embodiment;

FIG. 19 is a block diagram of an electronic device including an image sensor according to one or more example embodiments;

FIG. 20 is a block diagram of a camera module included in the electronic apparatus of FIG. 19.

DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

The disclosure will be described in detail below with reference to accompanying drawings. The example embodiments of the disclosure are capable of various modifications and may be embodied in many different forms. In the drawings, like reference numerals denote like components, and sizes of components in the drawings may be exaggerated for convenience of explanation.

Hereinafter, it will be understood that when a layer, region, or component is referred to as being "above" or "on" another layer, region, or component, it may be in contact with and directly on the other layer, region, or component, and intervening layers, regions, or components may be present.

It will be understood that although the terms "first," "second," etc. may be used herein to describe various components, these components should not be limited by these terms. These components are only used to distinguish one component from another. These terms do not limit that materials or structures of components are different from one another.

An expression used in the singular encompasses the expression of the plural, unless it has a clearly different meaning in the context. It will be further understood that when a portion is referred to as "comprises" another component, the portion may not exclude another component but may further comprise another component unless the context states otherwise.

Also, the terms "... unit", "... module" used herein specify a unit for processing at least one function or operation, and this may be implemented with hardware or software or a combination of hardware and software.

The use of the terms of "the above-described" and similar indicative terms may correspond to both the singular forms and the plural forms.

Also, the steps of all methods described herein may be performed in any suitable order unless otherwise indicated herein or otherwise clearly contradicted by context. Also, the use of all exemplary terms (for example, etc.) is only to describe technical detail, and the scope of rights is not limited by these terms unless the context is limited by the claims.

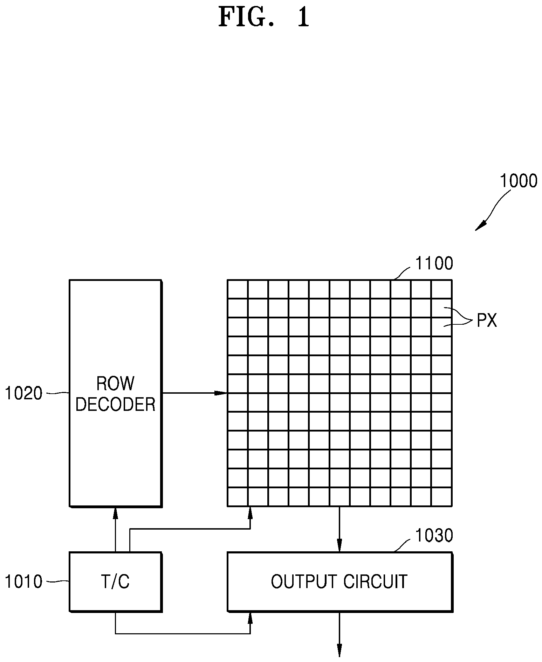

Referring to FIG. 1, the image sensor 1000 may include a pixel array 1100, a timing controller 1010, a row decoder 1020, and an output circuit 1030. The image sensor 1000 may include a charge-coupled device (CCD) image sensor or a complementary metal oxide semiconductor (CMOS) image sensor.

The pixel array 1100 includes pixels that are two-dimensionally arranged in a plurality of rows and columns. The row decoder 1020 selects one of the rows in the pixel array 1100 in response to a row address signal output from the timing controller 1010. The output circuit 1030 outputs a photosensitive signal, in a column unit, from a plurality of pixels arranged in the selected row. To this end, the output circuit 1030 may include a column decoder and an analog-to-digital converter (ADC). For example, the output circuit 1030 may include a plurality of ADCs that are arranged respectively to columns between the column decoder and the pixel array 1100, or one ADC arranged at an output end of the column decoder. The timing controller 1010, the row decoder 1020, and the output circuit 1030 may be implemented as one chip or separate chips. A processor for processing an image signal output from the output circuit 1030 may be implemented as one chip along with the timing controller 1010, the row decoder 1020, and the output circuit 1030.

The pixel array 1100 may include a plurality of pixels PX that sense light of different wavelengths. The pixel arrangement may be implemented in various ways. The pixel array 1100 may include a color separating lens array that separates incident light according to wavelengths so that light of different wavelengths may be incident on the plurality of pixels PX.

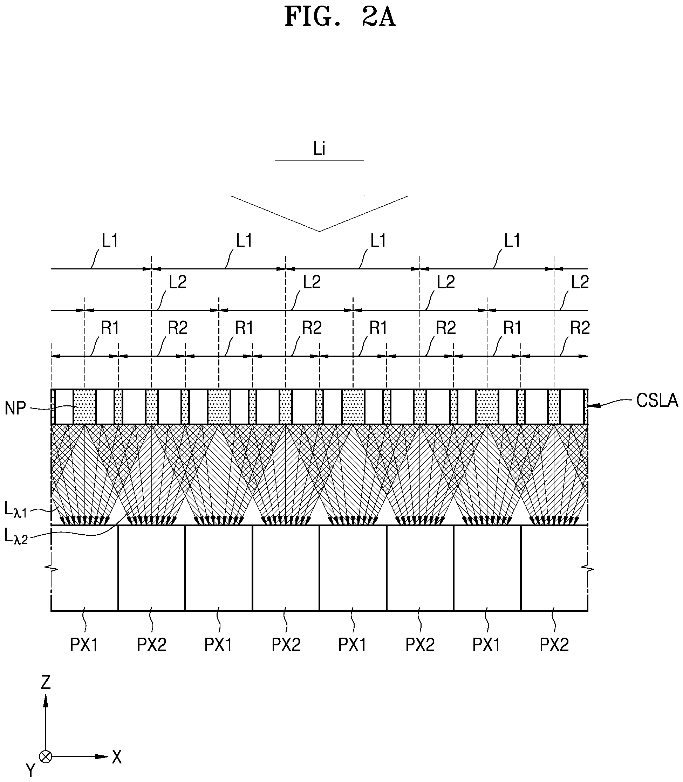

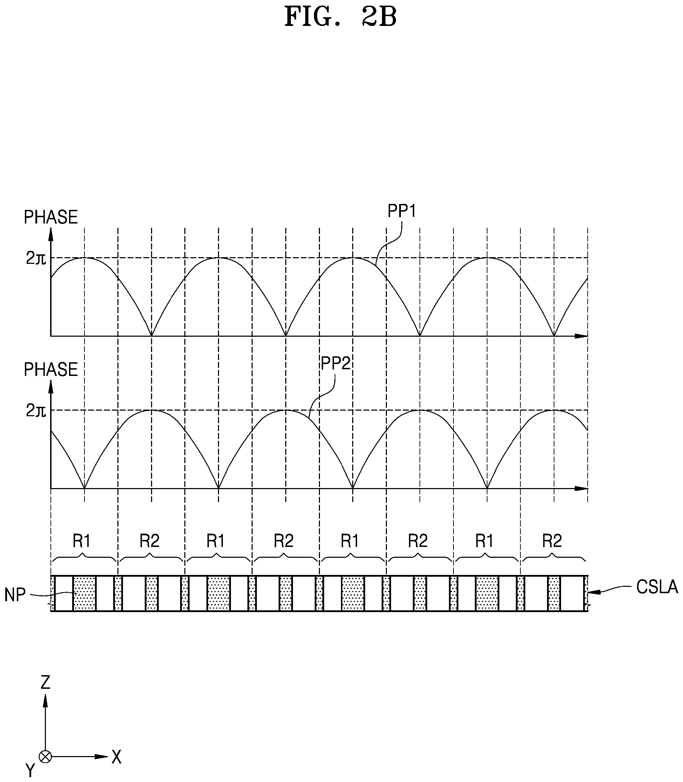

FIGS. 2A and 2B are conceptual diagrams showing a schematic structure and operations of a color separating lens array included in an image sensor according to an example embodiment.

Referring to FIG. 2A, a color separating lens array CSLA may include a plurality of nanoposts NP that change a phase of incident light Li differently from incident locations thereof. The color separating lens array CSLA may be partitioned in various ways. For example, the color separating lens array CSLA may be partitioned as a first pixel corresponding region R1 corresponding to a first pixel PX1 on which first wavelength light $L_{\lambda 1}$ included in the incident light Li is condensed, and a second pixel corresponding region R2 corresponding to a second pixel PX2 on which second wavelength light $L_{\lambda 2}$ included in the incident light Li is condensed. Each of the first and second pixel corresponding regions R1 and R2 may include one or more nanoposts NP, and the first and second pixel corresponding regions R1 and R2 may respectively face the first and second pixels PX1 and PX2. In another example, the color separating lens array CSLA may be partitioned as a first wavelength light condensing region L1 for condensing the first wavelength light $L_{\lambda 1}$ onto the first pixel PX1 and a second wavelength light condensing region L2 for condensing the second wavelength light $L_{\lambda 2}$ onto the second pixel PX2. The first wavelength light condensing regions L1 and the second wavelength light condensing regions L2 may partially overlap each other.

The color separating lens array CSLA may generate different phase profiles of the first wavelength light $L_{\lambda 1}$ and the second wavelength light $L_{\lambda 2}$ included in the incident light Li so that the first wavelength light $L_{\lambda 1}$ may be condensed onto the first pixel PX1 and the second wavelength light $L_{\lambda 2}$ may be condensed onto the second pixel PX2.

For example, referring to FIG. 2B, the color separating lens array CSLA may allow the first wavelength light $L_{\lambda 1}$ to have a first phase profile PP1 and the second wavelength light $L_{\lambda 2}$ to have a second phase profile PP2 at a position immediately after passing through the color separating lens array CSLA, e.g., on a lower surface of the color separating lens array CSLA, such that the first wavelength light $L_{\lambda 1}$ and the second wavelength light $L_{\lambda 2}$ may be respectively condensed on the corresponding first pixel PX1 and the second pixel PX2. In detail, the first wavelength light $L_{\lambda 1}$ that has passed through the color separating lens array CSLA may have the phase profile that is largest at the center of the first pixel corresponding region R1 and reduces away from the center of the first pixel corresponding region R1, that is, toward the second pixel corresponding regions R2. Such a phase profile is similar to a phase profile of light converging to one point after passing through a convex lens, e.g., a micro-lens disposed in a position of the first wavelength light condensing region L1 and having a convex center, and the first wavelength light $L_{\lambda 1}$ may be condensed onto the first pixel PX1. Also, the second wavelength light $L_{\lambda 2}$ that has passed through the color separating lens array CSLA has the phase profile that is largest at the center of the second pixel corresponding region R2 and reduces away from the center of the second pixel corresponding region R2, e.g., toward the first pixel corresponding regions R1, and thus, the second wavelength light $L_{\lambda 2}$ may be condensed onto the second pixel PX2.

Because a refractive index of a material varies depending on a wavelength of light, the color separating lens array CSLA may provide different phase profiles with respect to the first and second wavelength light $L_{\lambda 1}$ and $L_{\lambda 2}$. In other words, because the same material has a different refractive index according to the wavelength of light reacting with the material and a phase delay of the light that passes through the material is different according to the wavelength, the phase profile may vary depending on the wavelength. For example, a refractive index of the first pixel corresponding region R1 with respect to the first wavelength light $L_{\lambda 1}$ and a refractive index of the first pixel corresponding region R1 with respect to the second wavelength light $L_{\lambda 2}$ may be different from each other, and the phase delay of the first wavelength light $L_{\lambda 1}$ that passed through the first pixel corresponding region R1 and the phase delay of the second wavelength light $L_{\lambda 2}$ that passed through the first pixel corresponding region R1 may be different from each other. Therefore, when the color separating lens array CSLA is designed based on the characteristics of light, different phase profiles may be provided with respect to the first wavelength light $L_{\lambda 1}$ and the second wavelength light $L_{\lambda 2}$.

The color separating lens array CSLA may include nanoposts NP that are arranged according to a certain rule such that the first and second wavelength light $L_{\lambda 1}$ and $L_{\lambda 2}$ may respectively have first and second phase profiles PP1 and PP2. Here, the rule may be applied to parameters, such as the shape of the nanoposts NP, sizes (width and height), a distance between the nanoposts NP, and the arrangement form thereof, and these parameters may be determined according to a phase profile to be implemented by the color separating lens array CSLA.

A rule in which the nanoposts NP are arranged in the first pixel corresponding region R1, and a rule in which the nanoposts NP are arranged in the second pixel corresponding region R2 may be different from each other. In other words, sizes, shapes, intervals, and/or arrangement of the nanoposts NP in the first pixel corresponding region R1 may be different from those of the nanoposts NP in the second pixel corresponding region R2.

The nanoposts NP may have a shape dimension of a sub wavelength. Here, the sub-wavelength refers to a wavelength that is less than a wavelength band of light to be branched. The nanoposts NP may have a dimension that is less than a shorter wavelength of the first wavelength and the second wavelength. The nanoposts NP may have a cylindrical shape having a cross-sectional diameter of a sub wavelength. However, the shape of the nanoposts NP is not limited thereto, that is, the nanoposts NP may have an elliptical post shape or a polygonal post shape. Otherwise, the nanoposts NP may have post shapes having symmetrical or asymmetrical cross-sectional shape. The nanoposts NP are shown so that a width in the direction perpendicular to a height direction (Z-direction) is constant, that is, a cross-section parallel to the height direction has a rectangular shape, but the above shape is an example. Unlike the example, the widths of the nanoposts NP in the direction perpendicular to the height direction may not be consistent, for example, the cross-section parallel to the height direction may have a trapezoidal shape or an inversed trapezoidal shape. When the incident light Li is a visible ray, the cross-sectional diameter of the nanoposts NP may be less than, for example, 400 nm, 300 nm, or 200 nm.

In addition, a height of the nanoposts NP may be about 500 nm to about 1500 nm, which is greater than the cross-sectional diameter of the nanopost. According to an example embodiment, the nanoposts NP may be obtained by combining two or more posts stacked in the height direction (Z direction). The height of the nanoposts NP may be a few times greater than the sub wavelength to a wavelength. For example, the height of the nanoposts NP may be five times, four times, or three times or less the peak wavelength of a wavelength band separated by the color separating lens array CSLA. The nanoposts NP included in different pixel corresponding regions R1 and R2 are shown to have the identical height, but one or more example embodiments are not limited thereto, that is, the arrangement type, widths, and the number of the nanoposts NP are the examples. The widths, heights, the number, and arrangement type of the nanoposts NP may be determined to be suitable for forming the phase profile for color separation, or may be determined considering detailed processing conditions.

A peripheral material layer having a refractive index that is different from that of the nanoposts NP may be filled among the nanoposts NP. The nanoposts NP may include a material having a higher refractive index than that of a peripheral material. For example, the nanoposts NP may include c-Si, p-Si, a-Si and a Group III-V compound semiconductor (GaP, GaN, GaAs etc.), SiC, $TiO_2$, SiN, and/or a combination thereof. The nanoposts NP having a different refractive index from the refractive index of the peripheral material may change the phase of light that passes through the nanoposts NP. This is caused by phase delay that occurs due to the shape dimension of the sub-wavelength of the nanoposts NP, and a degree at which the phase is delayed, may be determined by a detailed shape dimension and arrangement shape of the nanoposts NP. A peripheral material of the nanoposts NP may include a dielectric material having a lower refractive index than that of the nanoposts NP. For example, the peripheral material may include $SiO_2$ or air. However, one or more example embodiments are not limited thereto, that is, the materials of the nanoposts NP and the peripheral material may be set so that the nanoposts NP may have a lower refractive index than that of the peripheral material.

Division of regions in the color separating lens array CSLA and shapes and arrangement of the nanoposts NP may be set so that a phase profile which allows the incident light to be separated according to wavelengths and to condense to the plurality of pixels PX1 and PX2 may be obtained. The separation according to wavelength may include a color separation in the visible ray band, but is not limited thereto, that is, the wavelength band may be expanded to the visible ray to infrared ray range, or other various ranges. A first wavelength $\lambda_1$ and a second wavelength $\lambda_2$ may be in a wavelength band of infrared rays and visible rays. However, one or more embodiments are not limited thereto, and a variety of wavelength bands may be included according to the rule of arrays of the plurality of nanoposts NP. Also, an example in which two wavelengths are separated and condensed is shown. However, embodiments are not limited thereto. The incident light may be branched into three directions or more according to wavelengths and condensed.

Also, the nanoposts NP in the color separating lens array CSLA is arranged in a single layer, but the color separating lens array CSLA may have a stack structure in which the nanoposts NP are arranged in a plurality of layers.

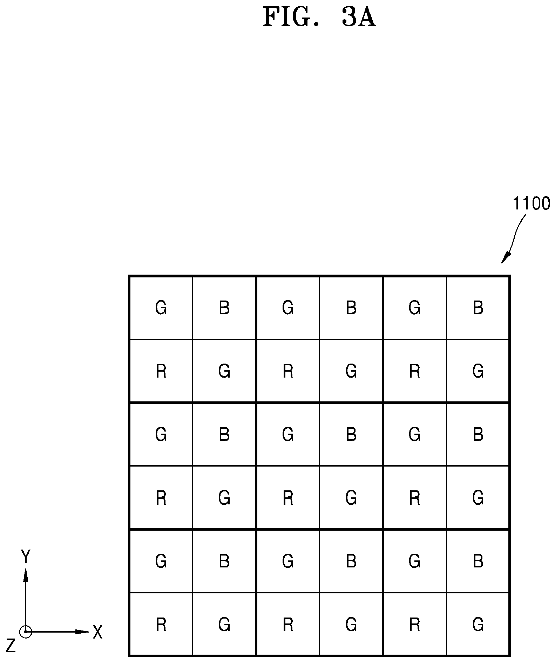

FIG. 3A is a plan view showing a color arrangement of the pixel array in the image sensor according to the example embodiment.

The color arrangement shown in FIG. 3A is a Bayer pattern arrangement generally adopted in an image sensor. As shown in FIG. 3A, one unit pattern may include four quadrant regions, and first to fourth quadrant regions may respectively indicate blue (B), green (G), red (R), and green (G). The unit patterns may be repeatedly and two-dimensionally arranged in a first direction (X direction) and a second direction (Y direction). For the above color arrangement, two green pixels are arranged in one diagonal direction and one blue pixel and one red pixel are arranged in another diagonal direction in a unit pattern of a 2×2 array. In other words, a first row in which a plurality of green pixels and a plurality of blue pixels are alternately arranged in the first direction and a second row in which a plurality of red pixels and a plurality of green pixels are alternately arranged in the first direction may be repeatedly arranged in the second direction.

The color arrangement of FIG. 3A is an example, and one or more example embodiments are not limited thereto. For example, a CYGM method, in which magenta (M), cyan (C), yellow (Y), and green (G) are represented in one unit pattern, or an RGBW method in which green, red, blue, and white are represented in one unit pattern may be used. Also, the unit patterns may be implemented in a 3x2 array, and the pixels in the pixel array 1100 may be arranged in various ways according to color characteristics of the image sensor 1000. Hereinafter, it will be described that the pixel array 1100 of the image sensor 1000 has the Bayer pattern, but the operating principles may be applied to other patterns of pixel arrangements than the Bayer pattern.

The pixel array 1100 of the image sensor 1000 may include a color separating lens array so as to correspond to the above color arrangement, that is, the color separating lens array condensing light of a color corresponding to a certain pixel. That is, the division of regions and the shapes and arrangement of the nanoposts NP may be set so that wavelengths separated by the color separating lens array CSLA described above with reference to FIGS. 2A and 2B may include a red wavelength, a green wavelength, and a blue wavelength.

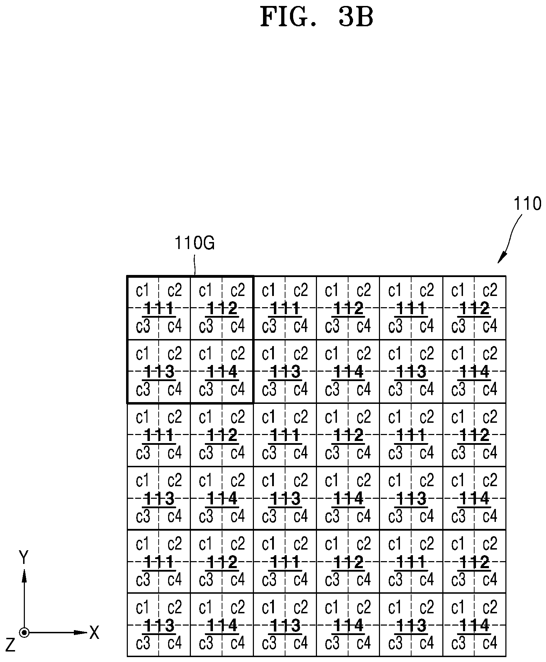

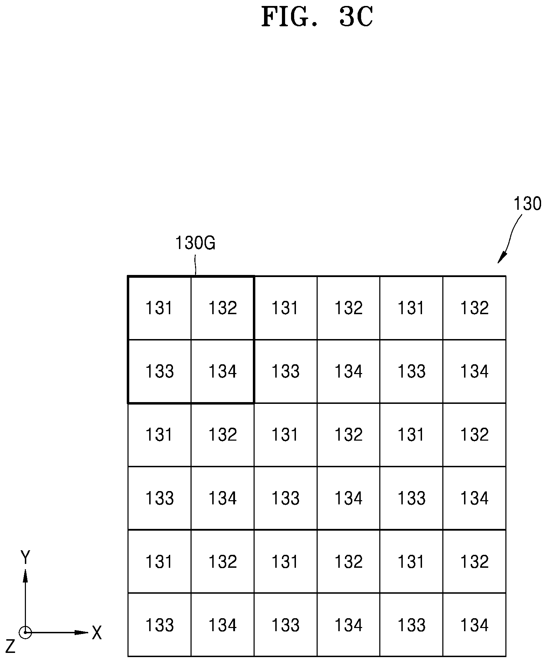

FIGS. 3B and 3C are plan views showing a sensor substrate 110 and the color separating lens array included in the pixel array of the image sensor according to the example embodiment.

Referring to FIG. 3B, the sensor substrate 110 may include a plurality of pixels sensing incident light. The sensor substrate 110 may include a plurality of unit pixel groups 11 0G. The unit pixel group 110G may include a first pixel 111, a second pixel 112, a third pixel 113, and a fourth pixel 114 that generate image signals by converting incident light into electrical signals. The unit pixel group 110G may include a pixel arrangement in the Bayer pattern type. The pixel arrangement in the sensor substrate 110 is for sensing the incident light after distinguishing the incident light according to unit patterns such as the Bayer patterns, as shown in FIG. 3A. For example, the first and fourth pixels 111 and 114 may be green pixels sensing green light, the second pixel 112 may be a blue pixel sensing blue light, and the third pixel 113 may be a red pixel sensing red light. Hereinafter, the pixel arrangement of the image sensor may be used interchangeably with the pixel arrangement of the sensor substrate. Also, hereinafter, the first pixel 111 and the fourth pixel 114 may be interchangeably referred to as a first green pixel and a second green pixel, the second pixel 112 may be interchangeably referred to as a blue pixel, and the third pixel 113 may be interchangeably referred to as a red pixel. However, one or more embodiments are not limited thereto.

Each of the first to fourth pixels 111, 112, 113, and 114 may include a plurality of photosensitive cells that independently sense incident light. For example, each of the first to fourth pixels 111, 112, 113, and 114 may include first to fourth photosensitive cells $c_1$, $c_2$, $c_3$, and $c_4$. The first to fourth photosensitive cells $c_1$, $c_2$, $c_3$, and $c_4$ may be two-dimensionally arranged in the first direction (X direction) and the second direction (Y direction). For example, in each of the first to fourth pixels 111, 112, 113, and 114, the first to fourth photosensitive cells $c_1$, $c_2$, $c_3$, and $c_4$ may be arranged in a 2x2 array.

FIG. 3B shows an example in which each of the first to fourth pixels 111, 112, 113, and 114 includes four photosensitive cells, but four or more independent photosensitive cells may be grouped and two-dimensionally arranged. For example, each of the first to fourth pixels 111, 112, 113, and 114 may include a plurality of independent photosensitive cells that are grouped and arranged in a 3x3 array or 4x4 array. Hereinafter, an example in which each of the first to fourth pixels 111, 112, 113, and 114 includes the photosensitive cells arranged in a 2x2 array will be described for convenience of description.

According to the example embodiment, some of the plurality of pixels each including the plurality of photosensitive cells sensing the light of the same color may be used as auto-focusing pixels. In the auto-focusing pixel, an auto-focusing signal may be obtained from a difference between output signals of adjacent photosensitive cells. For example, an auto-focusing signal in the first direction (X direction) may be generated from a difference between output signals from the first photosensitive cell $c_1$ and the second photosensitive cell $c_2$, a difference between output signals from the third photosensitive cell $c_3$ and the fourth photosensitive cell $c_4$, or a difference between a sum of the output signals from the first photosensitive cell $c_1$ and the third photosensitive cell $c_3$ and a sum of the output signals from the second photosensitive cell c2 and the fourth photosensitive cell c4. Also, an auto-focusing signal in the second direction (Y direction) may be generated from a difference between output signals from the first photosensitive cell c1 and the third photosensitive cell c3, a difference between output signals from the second photosensitive cell c2 and the fourth photosensitive cell c4, or a difference between a sum of the output signals from the first photosensitive cell c1 and the second photosensitive cell c2 and a sum of the output signals from the third photosensitive cell c3 and the fourth photosensitive cell c4.

In addition, a general image signal may be obtained by adding output signals from the first to fourth photosensitive cells c1, c2, c3, and c4. For example, a first green image signal may be generated by adding the output signals from the first to fourth photosensitive cells c1, c2, c3, and c4 of the first pixel 111, a blue image signal may be generated by adding the output signals from the first to fourth photosensitive cells c1, c2, c3, and c4 of the second pixel 112, a red image signal may be generated by adding the output signals from the first to fourth photosensitive cells c1, c2, c3, and c4 of the third pixel 113, and a second green image signal may be generated by adding the output signals from the first to fourth photosensitive cells c1, c2, c3, and c4 of the fourth pixel 114.

Referring to FIG. 3C, a color separating lens array 130 may include a plurality of groups of regions corresponding to the plurality of unit pixel groups 110G of the sensor substrate 110 shown in FIG. 3B. For example, the color separating lens array 130 includes a plurality of pixel corresponding groups 130G respectively corresponding to the plurality of unit pixel groups 110G of the sensor substrate 110 shown in FIG. 3B. The pixel corresponding group 130G includes first to fourth pixel corresponding regions 131, 132, 133, and 134 corresponding to the first to fourth pixels 111, 112, 113, and 114. The first to fourth pixel corresponding regions 131, 132, 133, and 134 each include a plurality of nanoposts. The plurality of nanoposts are configured to separate incident light according to wavelengths and condense the light to the corresponding first to fourth pixels 111, 112, 113, and 114 according to the wavelengths. As described above with reference to FIG. 3B, the first pixel 111 and the fourth pixel 114 may be respectively a first green pixel and a second green pixel, the second pixel 112 may be a blue pixel, and the third pixel 113 may be a red pixel. In this case, the first pixel corresponding region 131 and the fourth pixel corresponding region 134 may be interchangeably referred to as a first green pixel corresponding region and a second green pixel corresponding region, the second pixel corresponding region 132 may be interchangeably referred to as a blue pixel corresponding region, and the third pixel corresponding region 133 may be interchangeably referred to as a red pixel corresponding region.

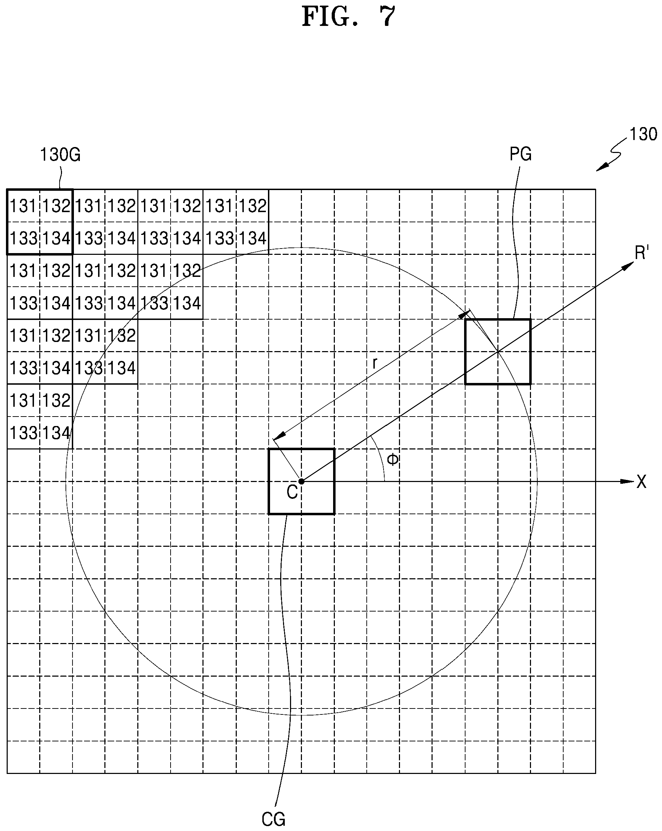

The shapes and arrangement of the plurality of nanoposts included in the color separating lens array 130 may be set to form a phase profile that is appropriate to the wavelength separation, and the detailed shape and arrangement of the nanoposts may be adjusted according to a relative position of the pixel corresponding group 130G in which the nanoposts are included in the color separating lens array 130. This will be described in detail later with reference to FIGS. 7 to 16.

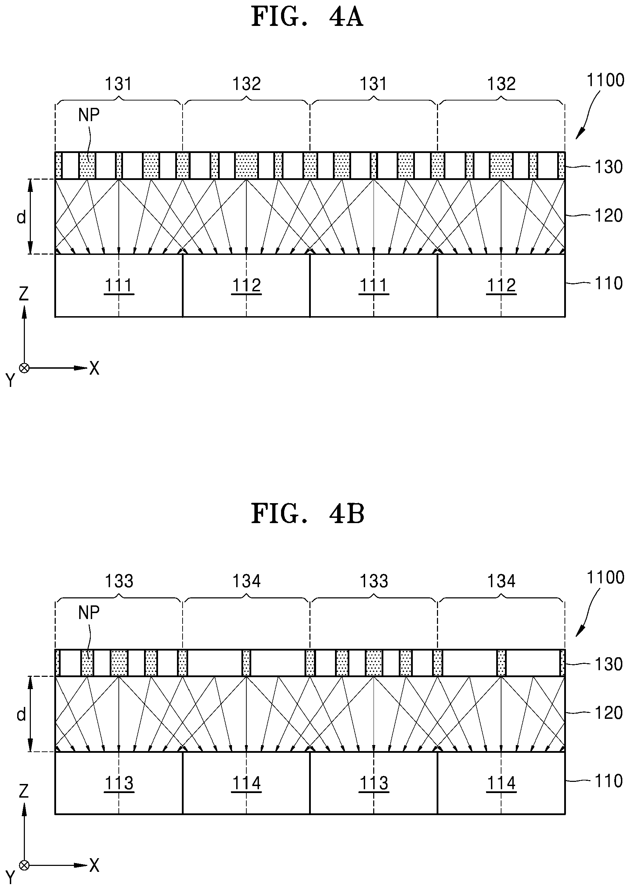

FIGS. 4A and 4B are cross-sectional views of the pixel array 1100, seen from different cross-sections, in the image sensor of FIG. 1.

Referring to FIGS. 4A and 4B, the pixel array 1100 of the image sensor 1000 includes the sensor substrate 110 and the color separating lens array 130 arranged on the sensor substrate 110.

The sensor substrate 110 may include the first pixel 111, the second pixel 112, the third pixel 113, and the fourth pixel 114 sensing light as described above with reference to FIG. 3B, and each of the first pixel 111, the second pixel 112, the third pixel 113, and the fourth pixel 114 may include a plurality of photosensitive cells. According to an example embodiment, a separator for separating cells may be further formed on a boundary between cells.

A transparent spacer layer 120 may be arranged between the sensor substrate 110 and the color separating lens array 130. According to an example embodiment, a color filter array may be further arranged between the sensor substrate 110 and the spacer layer 120. The color filter array may include a red filter, a green filter, and a blue filter, and the filters may be arranged corresponding to the color arrangement as shown in FIG. 3A, for example. Because the color separating lens array 130 performs the color separation in the example embodiment, adding of the color filter array may improve a color purity by supplementing some errors that may occur during the color separation of the color separating lens array 130.

The spacer layer 120 supports the color separating lens array 130 and may have a thickness d that satisfies a regulation about a distance between the sensor substrate 110 and the color separating lens array 130, that is, a distance between an upper surface of the sensor substrate 110 and a lower surface of the color separating lens array 130. The thickness of the spacer layer 120 may vary depending on whether the color filter array is provided between the color separating lens array 130 and the sensor substrate 110.

The spacer layer 120 may include a material transparent with respect to the visible ray, for example, a dielectric material having a lower refractive index than that of the nanoposts NP and low absorption coefficient in the visible ray band, e.g., $SiO_2$, siloxane-based spin on glass (SOG), etc. When the peripheral material layer filled among the nanoposts NP has a higher refractive index than that of the nanoposts NP, the spacer layer 120 may include a material having a lower refractive index than that of the peripheral material layer.

A thickness d of the spacer layer 120 may be selected within a range of ht - p ≤ d ≤ ht + p. Here, ht denotes a focal length of light at the peak wavelength in a wavelength band branched by the color separating lens array 130, and p denotes a pixel pitch. In an example embodiment, the pixel pitch may be a few $\mu$m or less, for example, 2 $\mu$m or less, 1.5 $\mu$m or less, 1 $\mu$m or less, or 0.7 $\mu$m or less. The pixel pitch may be within a range of about 0.5 $\mu$m to about 1.5 $\mu$m. The thickness of the spacer layer 120 may be designed based on, for example, the center wavelength of the green light, that is, 540 nm.

When the color filter array is arranged between the sensor substrate 110 and the color separating lens array 130, in consideration of the thickness of the color filter array, the thickness of the spacer layer 120 may be set to be less than the focal length of the color separating lens array 130 with respect to the light of the center wavelength from among the wavelength bands separated by the color separating lens array 130. For example, the thickness may be set to be less than a focal length of the green light by the color separating lens array 130.

According to an example embodiment, an etch-stop layer may be further provided between the spacer layer 120 and the color separating lens array 130. The etch-stop layer may be provided to protect the spacer layer 120 that is the structure under the color separating lens array 130, during the process of manufacturing the color separating lens array 130. For example, a condition about the distance between the lower surface of the color separating lens array 130 and the upper surface of the sensor substrate 110 may be maintained due to the etch-stop layer.

Also, a protective layer for protecting the color separating lens array 130 may be further disposed on the color separating lens array 130. The protective layer may include a material functioning as an anti-reflection layer.

The first green pixel corresponding region 131 corresponds to the first green pixel 111 and may be on the first green pixel 111, the blue pixel corresponding region 132 corresponds to the blue pixel 112 and may be on the blue pixel 112, the red pixel corresponding region 133 corresponds to the red pixel 113 and may be on the red pixel 113, and the second green pixel corresponding region 134 corresponds to the second green pixel 114 and may be on the second green pixel 114. That is, the first to fourth pixel corresponding regions 131, 132, 133, and 134 of the color separating lens array 130 may be arranged respectively facing the pixels 111, 112, 113, and 114 of the sensor substrate 110. As shown in FIG. 3C, the first to fourth pixel corresponding regions 131, 132, 133, and 134 may be two-dimensionally arranged in the first direction (X direction) and the second direction (Y direction) such that a first row in which the first green pixel corresponding region 131 and the blue pixel corresponding region 132 are alternately arranged and a second row in which the red pixel corresponding region 133 and the second green pixel corresponding region 134 are alternately arranged are alternately repeated.

In addition, similar to the above description with reference to FIG. 2A, the area of the color separating lens array 130 may be described to include a green light condensing region for condensing the green light, a blue light condensing region for condensing the blue light, and a red light condensing region for condensing the red light.

Sizes, shapes, intervals, and/or arrangement of the plurality of nanoposts NP included in the color separating lens array 130 may be determined such that the green light is separated and condensed to the first and second green pixels 111 and 114, the blue light is separated and condensed to the blue pixel 112, and the red light is separated and condensed to the red pixel 113.

A pixel arrangement characteristic of the Bayer pattern may be reflected to the arrangement of the nanoposts in the pixel corresponding regions 131, 132, 133, and 134. In the Bayer pattern pixel arrangement, adjacent pixels to the blue pixel 112 and the red pixel 113 in the first direction (X direction) and the second direction (Y direction) are same as the green pixels G, whereas the adjacent pixel to the first green pixel 111 in the first direction (X direction) is the blue pixel 112 and the adjacent pixel to the first green pixel 111 in the second direction (Y direction) is the red pixel R. In addition, the adjacent pixel to the second green pixel 114 in the first direction (X direction) is the red pixel 113 and the adjacent pixel to the second green pixel 114 in the second direction (Y direction) is the blue pixel 114. In addition, adjacent pixels to the first and second green pixels 111 and 114 in four diagonal directions are green pixels, adjacent pixels to the blue pixel 112 in the four diagonal directions are the red pixels 113, and adjacent pixels to the red pixel 113 in the four diagonal directions are the blue pixels 112. Therefore, in the blue and red pixel corresponding regions 132 and 133 respectively corresponding to the blue pixel 112 and the red pixel 113, the nanoposts NP may be arranged in the form of 4-fold symmetry, and in the first and second green pixel corresponding regions 131 and 134, the nanoposts NP may be arranged in the form of 2-fold symmetry. The arrangement of nanoposts 1 in the first and second green pixel corresponding regions 131 and 134 may be rotated by 90° angle with respect to each other.

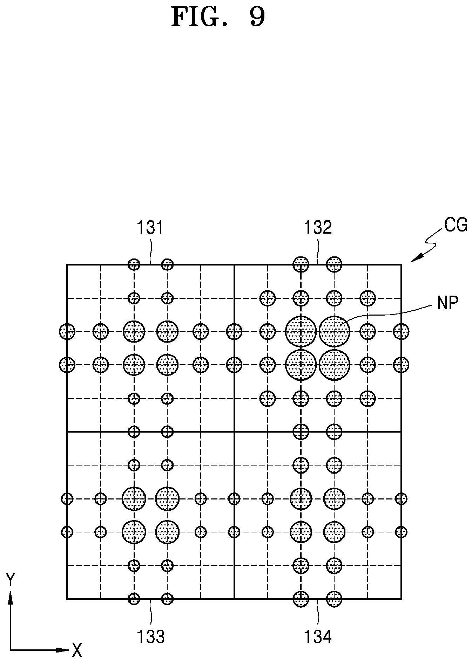

As shown in the plan view of FIG. 9 that will be described later, the arrangement of the nanoposts NP in the first to fourth pixel corresponding regions 131, 132, 133, and 134 may be an example of reflecting the arrangement rule. Unlike FIG. 9 shows that the nanoposts NP in the first and second green pixel corresponding regions 131 and 134 and the blue and red pixel corresponding regions 132 and 133 have symmetrical cross-sections having the identical widths in the first direction (X direction) and the second direction (Y direction), the nanoposts NP in the first and second green pixel corresponding regions 131 and 134 may have asymmetrical cross-sections having different widths in the first direction (X direction) and the second direction (Y direction). The arrangement rule of the nanoposts NP is an example for separating wavelengths corresponding to the pixel arrangement, and is not limited to the example description or pattern shown in the drawings.

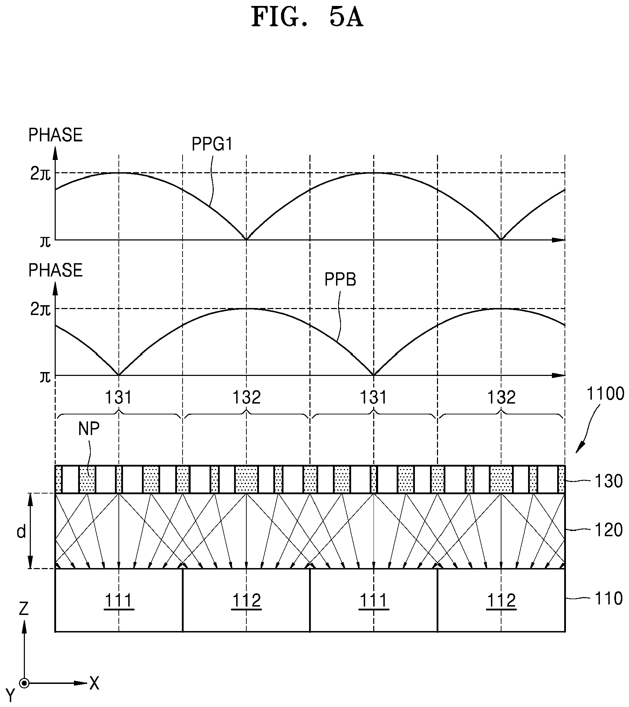

FIG. 5A is a diagram showing phase profiles of green light and blue light that have passed through a color separating lens array on a cross-section of FIG. 4A.

Referring to FIG. 5A, the green light that has passed through the color separating lens array 130 may have a first green light phase profile PPG1 that is the largest at the center of the first green pixel corresponding region 131 and is reduced away from the center of the first green pixel corresponding region 131. In detail, immediately after passing through the color separating lens array 130, that is, at a lower surface of the color separating lens array 130 or an upper surface of the spacer layer 120, the phase of the green light is the largest at the center of the first green pixel corresponding region 131 and reduced as a concentric circle away from the center of the first green pixel corresponding region 131. Thus, the phase is the smallest at the centers of the blue and red pixel corresponding regions 132 and 133 in the X and Y directions, and at contact points between the first green pixel corresponding region 131 and the second green pixel corresponding region 134 in the diagonal direction. When a phase of the green light is set as $2\pi$ based on the phase of light emitted from the center of the first green pixel corresponding region 131, the light having a phase of about $0.9\pi$ to about $1.1\pi$ may be emitted from the centers of the blue and red pixel corresponding regions 132 and 133, and the light having a phase of about $1.1\pi$ to about $1.5\pi$ may be emitted from a contact point between the first green pixel corresponding region 131 and the second green pixel corresponding region 134. Therefore, a difference between the phase of the green light that has passed through the center of the first green pixel corresponding region 131 and the phase of the green light that has passed through the centers of the blue and red pixel corresponding regions 132 and 133 may be about $0.9\pi$ to about $1.1\pi$.

In addition, the first green light phase profile PPG1 does not denote that the phase delay amount of the light that has passed through the center of the first green pixel corresponding region 131 is the largest, but when the phase of light that has passed through the first green pixel corresponding region 131 is $2\pi$ and a phase delay amount of the light that has passed through another point is greater and has a phase value of $2\pi$ or greater, the first green light phase profile PPG1 may denote a value remaining after subtracting $2n\pi$, that is, wrapped phase profile. For example, when the phase of light that has passed through the first green pixel corresponding region 131 is $2\pi$ and the phase of light that has passed through the center of the blue pixel corresponding region 132 is $3\pi$, the phase in the blue pixel corresponding region 132 may be remaining $\pi$ after subtracting $\pi$ (n=1) from $3\pi$.

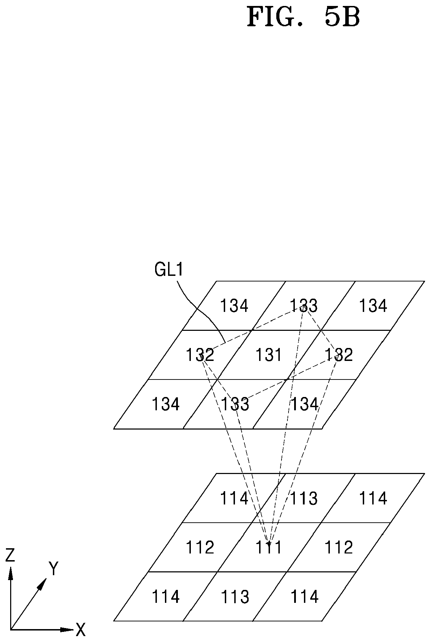

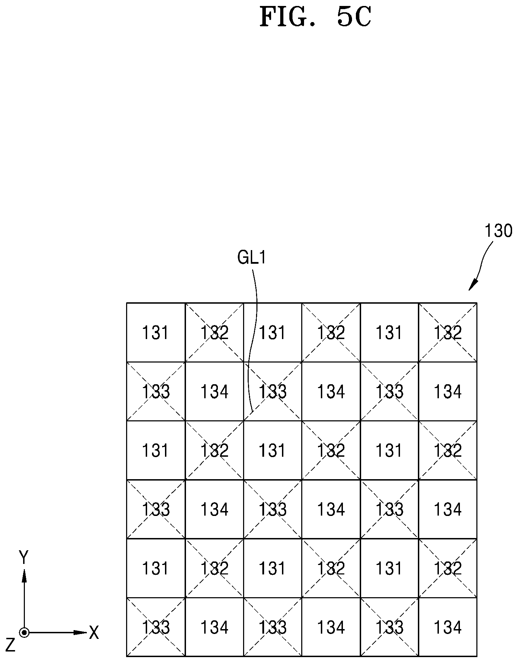

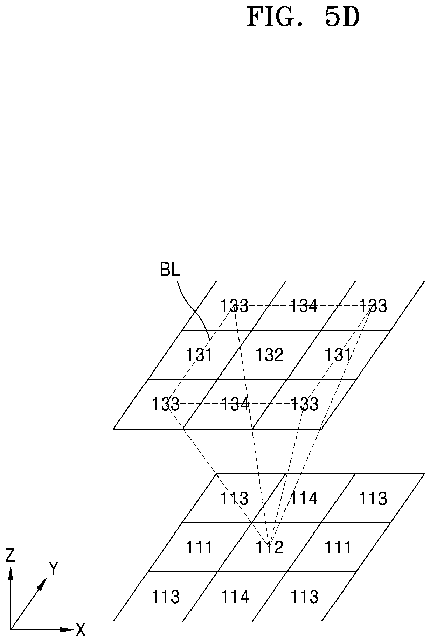

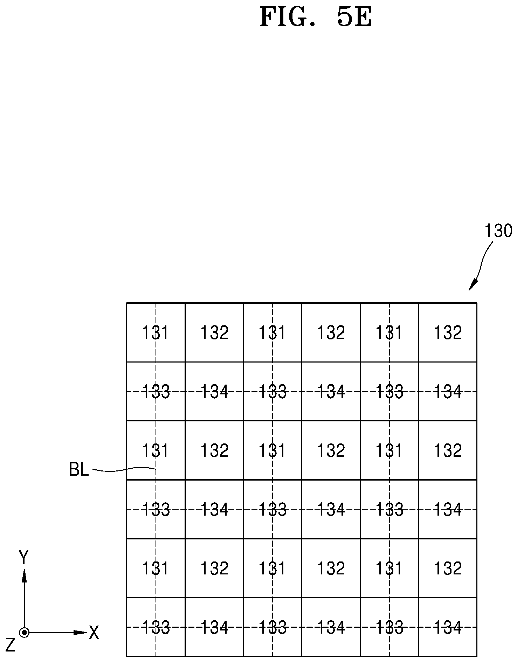

Also, the blue light that has passed through the color separating lens array 130 may have a blue light phase profile PPB that is largest at the center of the blue pixel corresponding region 132 and reduces away from the center of the blue pixel corresponding region 132. In detail, immediately after passing through the color separating lens array 130, the phase of the blue light is the largest at the center of the blue pixel corresponding region 132 and reduced as a concentric circle away from the center of the blue pixel corresponding region 132, the phase is the smallest at the centers of the first and second green pixel corresponding regions 131 and 134 in the X direction and the Y direction and the smallest at the center of the red pixel corresponding region 133 in the diagonal direction. When the phase of the blue light at the center of the blue pixel corresponding region 132 is $2\pi$, the phase at the centers of the first and second green pixel corresponding regions 131 and 134 may be about, for example, about $0.9\pi$ to about $1.1\pi$, and the phase at the center of the red pixel corresponding region 133 may be less than that at the centers of the first and second green pixel corresponding regions 131 and 134, for example, about $0.5\pi$ to about $0.9\pi$. FIGS. 5B and 5C are diagrams respectively showing examples of a proceeding direction of green light incident on a first green light condensing region and an array of the first green light condensing region, and FIGS. 5D and 5E are diagrams respectively showing examples of a proceeding direction of blue light incident to a blue light condensing region and an array of the blue light condensing region.

The green light incident on the first green pixel corresponding region 131 and the vicinity of the first green pixel corresponding region 131 is condensed to the first green pixel 111 by the color separating lens array 130, and the green light from the blue and red pixel corresponding regions 132 and 133, in addition to the first green pixel corresponding region 131, is also incident on the first green pixel 111. That is, according to the phase profile of the green light described above with reference to FIG. 5A, the green light that has passed through a first green light condensing region GL1 that is obtained by connecting centers of two blue pixel corresponding regions 132 and two red pixel corresponding regions 133 that are adjacent to the first green pixel corresponding region 131 is condensed onto the first green pixel 111. Therefore, as shown in FIG. 5C, the color separating lens array 130 may operate as a first green light condensing region array for condensing the green light onto the first green pixel 111. The first green light condensing region GL1 may have a greater area than that of the corresponding first green pixel 111, e.g., may be 1.2 times to two times greater than that of the first green pixel 111.

The blue light is condensed onto the blue pixel 112 by the color separating lens array 130, and the blue light from the pixel corresponding regions 131, 132, 133, and 134 is incident on the blue pixel 112. In the phase profile of the blue light described above, the blue light that has passed through a blue light condensing region BL that is obtained by connecting centers of four red pixel corresponding regions 133 adjacent to the blue pixel corresponding region 132 at apexes is condensed onto the blue pixel 112. Therefore, as shown in FIG. 5E, the color separating lens array 130 may operate as a blue light condensing region array for condensing the blue light to the blue pixel. The blue light condensing region BL has an area greater than that of the blue pixel 112, e.g., may be 1.5 to 4 times greater. The blue light condensing region BL may partially overlap the first green light condensing region GL1 described above, and a second green light condensing region GL2 and a red light condensing region RL that will be described later.

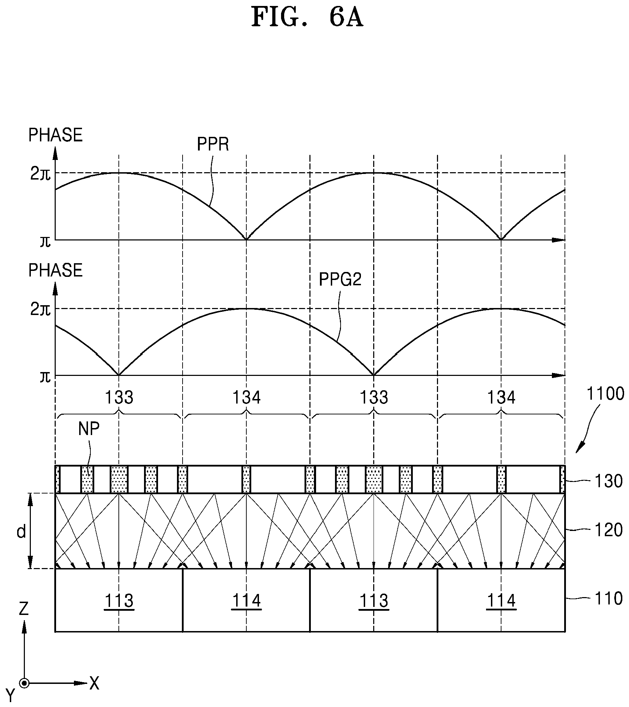

FIG. 6A is a diagram showing phase profiles of red light and green light that have passed through the color separating lens array 130 on a cross-section of FIG. 4B.

Referring to FIG. 6A, the red light that has passed through the color separating lens array 130 may have a red light phase profile PPR that is largest at the center of the red pixel corresponding region 133 and reduces away from the center of the red pixel corresponding region 133, similarly to the blue light described above with reference to FIG. 5A. When the phase of the red light at the center of the red pixel corresponding region 133 is $2\pi$, the phase at the centers of the first and second green pixel corresponding regions 131 and 134 may be about, for example, about $0.9\pi$ to about $1.1\pi$, and the phase at the center of the blue pixel corresponding region 132 may be less than that at the centers of the first and second green pixel corresponding regions 131 and 134, for example, about $0.5\pi$ to about $0.9\pi$.

Referring to FIG. 6A, the green light that has passed through the color separating lens array 130 may have a second green light phase profile PPG2 that is largest at the center of the second green pixel corresponding region 134 and reduces away from the center of the second green pixel corresponding region 134, similarly to the green light described above with reference to FIG. 5A. When comparing the first green light phase profile PPG1 of FIG. 5A with the second green light phase profile PPG2 of FIG. 6A, the second green light phase profile PPG2 is obtained by moving in parallel with the first green light phase profile PPG1 by one-pixel pitch in the X direction and the Y direction, and descriptions about the first green light phase profile PPG1 may be applied to the others.

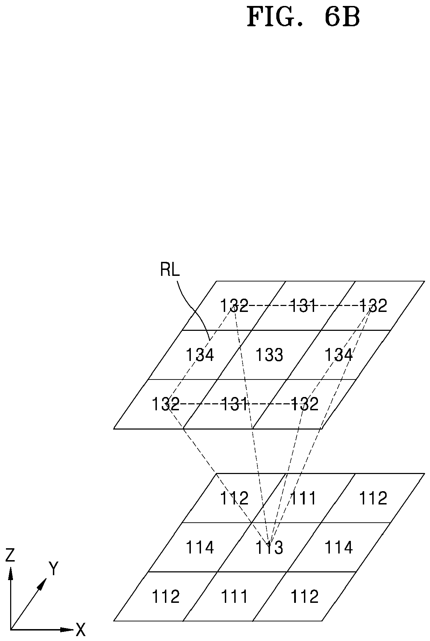

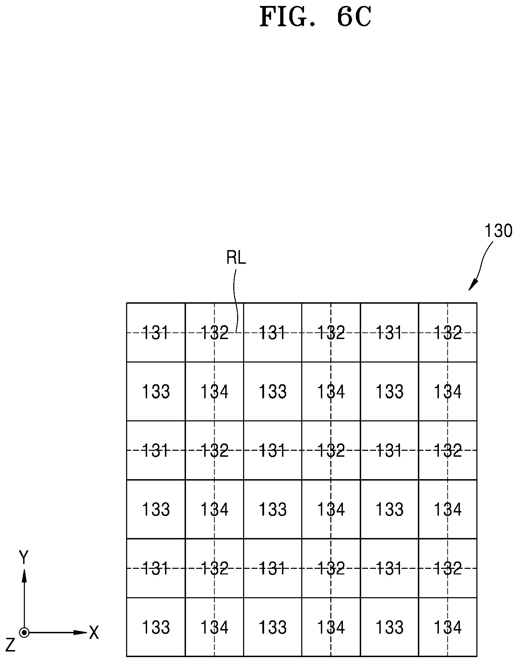

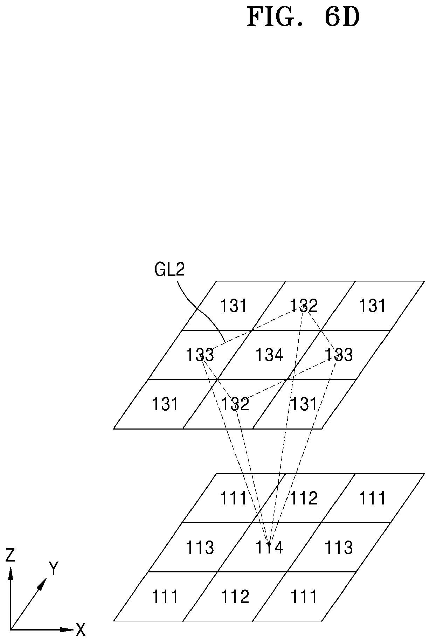

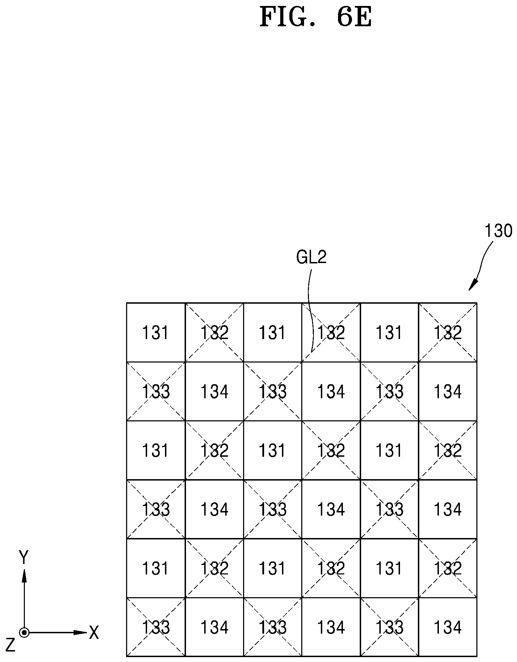

FIGS. 6B and 6C are diagrams respectively showing examples of a proceeding direction of red light incident on a red light condensing region and an array of the red light condensing region, and FIGS. 6D and 6E are diagrams respectively showing examples of a proceeding direction of green light incident to a second green light condensing region and an array of the second green light condensing region.

In the phase profile of the red light described above with reference to FIG. 6A, the red light that has passed through a red light condensing region RL that is obtained by connecting centers of four blue pixel corresponding regions 132 adjacent to the red pixel corresponding region 133 at apexes is condensed onto the red pixel 113. Therefore, as shown in FIG. 6C, the color separating lens array 130 may operate as a red light condensing region array for condensing the red light to the red pixel. The red light condensing region RL has an area greater than that of the red pixel 113, e.g., may be 1.5 to 4 times greater. The red light condensing region RL may partially overlap the first and second green light condensing regions GL1 and GL2 and the blue light condensing region BL.

The green light incident on the second green pixel corresponding region 134 and the vicinity of the second green pixel corresponding region 134 proceeds similarly to the green light incident on the first green pixel corresponding region 131 and the vicinity of the first green pixel corresponding region 131, and as shown in FIG. 6D, the green light is condensed onto the second green pixel 114. Therefore, as shown in FIG. 6E, the color separating lens array 130 may operate as a second green light condensing region array for condensing the green light onto the second green pixel 114. The second green light condensing region GL2 may have a greater area than that of the corresponding second green pixel 114, e.g., may be 1.2 times to twice greater.

The color separating lens array 130 satisfying the above phase profile and performance described above may be automatically designed through various types of computer simulations. For example, the structures of the pixel corresponding regions 131, 132, 133, and 134 may be optimized through a nature-inspired algorithm such as a genetic algorithm, a particle swarm optimization algorithm, an ant colony optimization algorithm, etc., or a reverse design based on an adjoint optimization algorithm.

The structures of the green, blue, and red pixel corresponding regions may be optimized while evaluating performances of a plurality of candidate color separating lens arrays based on evaluation factors such as color separation spectrum, optical efficiency, signal-to-noise ratio, etc. when designing the color separating lens array 130. For example, the structures of the green, blue, and red pixel corresponding regions may be optimized in a manner that a target numerical value of each evaluation factor is determined in advance and the sum of the differences from the target numerical values of a plurality of evaluation factors is reduced. Alternatively, the performance may be indexed for each evaluation factor, and the structures of the green, blue, and red pixel corresponding regions may be optimized so that a value representing the performance may be maximized.

An incidence angle of the light incident on the image sensor 1000 is typically defined as a chief ray angle (CRA). A chief ray denotes a light ray starting from a point of the object and arriving at the image sensor 1000 by passing through a center of an objective lens. The CRA denotes an angle formed by the chief ray with respect to an optical axis, and is generally equal to an incident angle of the chief ray incident on the image sensor 1000. For example, the chief ray of the light starting from a point on the optical axis of the objective lens is incident perpendicularly to the center portion of the image sensor 1000, and in this case, the CRA is 0°. As the starting point is away from the optical axis of the objective lens, the CRA increases and the light is incident on the edge of the image sensor 1000. From the viewpoint of the image sensor 1000, the CRA of the light incident on the center portion of the image sensor 1000 is 0° and the CRA of the incident light gradually increases away from the center of the image sensor 1000.

However, the color separating lens array 130 described above may generally have a directivity with respect to the incident light. In other words, the color separating lens array 130 efficiently operates with respect to the light incident on the color separating lens array within a certain angle range, but when the incidence angle is away from the certain angle range, the color separation performance of the color separating lens array 130 may degrade. Accordingly, when the nanoposts NP of the color separating lens array 130 have the same arrangement form in the entire area of the image sensor 1000, the color separation efficiency is not consistent throughout the entire area of the image sensor 1000 and may vary depending on regions in the image sensor 1000. Thus, the quality of the image provided by the image sensor 1000 may degrade.

In addition, when the plurality of pixels 111, 112, 113, and 114 each have a plurality of photosensitive cells, there may be a signal difference between the plurality of photosensitive cells corresponding to the identical pixel and is referred to as a channel difference. The channel difference may occur due to the structural variation that may be generated during a manufacturing processes and may also occur due to the CRA. Also, the light of different wavelengths has different focal lengths, and the channel difference due to the CRA may also vary depending on the wavelengths. The channel difference may degrade image quality obtained from the image sensor 1000. The channel difference may cause an error when an automatic focusing signal is generated. As described above with reference to FIG. 3B, when each of the plurality of pixels 111, 112, 113, and 114 includes the first to fourth photosensitive cells c1, c2, c3, and c4, for example, the automatic focusing signal may be obtained by using a difference between sum of the output signals from the first photosensitive cell c1 and the third photosensitive cell c3 and sum of the output signals from the second photosensitive cell c2 and the fourth photosensitive cell c4. When the difference has a value of 0, it may be determined that the image sensor 1000 is appropriately located on a focal plane of a module lens in the imaging device including the image sensor 1000. When the difference value is not 0, the module lens may be moved according to the difference value and the sign thereof so that the image sensor 1000 is located on the focal plane of the module lens. However, when there is the channel difference, the auto focusing signals may not be symmetrical with respect to 0°, and the accuracy of the auto focusing signal may degrade. Accordingly, the auto focusing signal needs to be generated considering the channel difference, and operations thereof may be complicated.

The image sensor 1000 according to the example embodiment may be designed so that the arrangement type of the nanoposts NP of the color separating lens array 130 may vary considering the CRA of the incident light, which varies depending on the location on the image sensor 130. For example, the arrangement of the nanoposts NP included in the plurality of pixel corresponding regions 131, 132, 133, and 134 of the color separating lens array 130 may be differently adjusted according to relative positional relationship based on the center of the color separating lens array 130. An azimuth and color, as well as the CRA, may be considered in aligning the nanoposts NP.

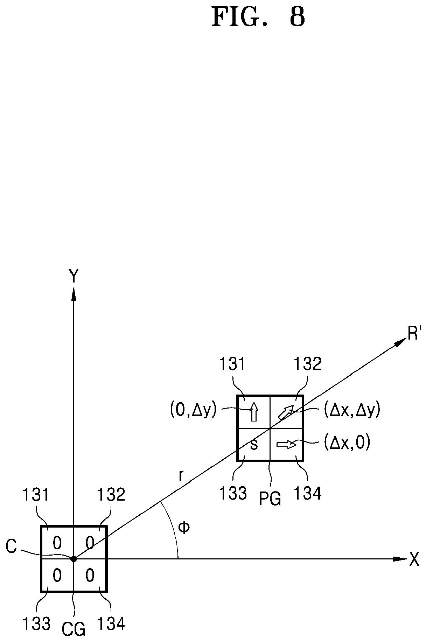

FIG. 7 is a plan view for defining pixel corresponding groups of a color separating lens array in an image sensor as a central group and one or more peripheral groups based on positions of the pixel corresponding groups in the color separating lens array according to an example embodiment, and for describing an azimuth direction according to an example embodiment. FIG. 8 is a plan view for describing locations of the nanoposts included in the pixel corresponding regions of the peripheral group in the color separating lens array of the image sensor according to the example embodiment, as compared with those of the central group.

Referring to FIG. 7, pixel corresponding groups 130G in the color separating lens array 130 may be two-dimensionally arranged in the first direction (X direction) and the second direction (Y direction). The pixel corresponding groups 130G may be defined as a central group CG and peripheral groups PG according to positions of the pixel corresponding groups 130G within the color separating lens array 130. According to an example embodiment, the central group CG denotes a pixel corresponding group located at the center of the color separating lens array 130, and the peripheral groups PG denote pixel corresponding groups provided away from the center of the color separating lens array 130. For example, the peripheral groups PG may be pixel corresponding group that are spaced apart from the central group CG, which is at the center of the color separating lens array 130. That is, other pixel corresponding groups than the central group CG. In the drawings, the number of the central group CG is one, but for the convenience in design, a plurality of pixel corresponding groups which are located at a center portion may be defined as a plurality of central group CG.

Referring to FIGS. 7 and 8, the position of the peripheral group PG may be represented as a distance r and an azimuth $\varphi$ from a center C of the color separating lens array 130. The azimuth $\varphi$ may be defined based on an axis that is in parallel to the first direction (X-axis) while passing through the center C of the color separating lens array 130. The distance r defining the position of the peripheral group PG is related to the CRA. When r is 0, that is, at the center C of the color separating lens array 130, the CRA is 0°, and as the distance r increases, the CRA also increases. Also, R' may be an axis passing through the center C of the center group CG and the peripheral group PG.

As shown in the example in FIG. 8, in the peripheral group PG, relative positional relationship among the nanoposts of the first pixel corresponding region 131, the nanoposts of the second pixel corresponding region 132, the nanoposts of the third pixel corresponding region 133, and the nanoposts of the fourth pixel corresponding region 134 is different from the relative positional relationship among the nanoposts of the first pixel corresponding region 131, the nanoposts of the second pixel corresponding region 132, the nanoposts of the third pixel corresponding region 133, and the nanoposts of the fourth pixel corresponding region 134 in the central group CG.

Referring to FIG. 8, in the central group CG, '0' indicated in the first pixel corresponding region 131, the second pixel corresponding region 132, the third pixel corresponding region 133, and the fourth pixel corresponding region 134 represents an alignment of the central pixel corresponding group CG with the corresponding pixel group facing the central pixel corresponding group CG. That is, '0' indicates that the central color separating lens central group CG is aligned with the corresponding pixel group facing the central pixel corresponding group CG . Moreover, the '0' in the first pixel corresponding region 131, the second pixel corresponding region 132, the third pixel corresponding region 133, and the fourth pixel corresponding region 134 may represent a reference for the relative positional relationship in the peripheral group PG.

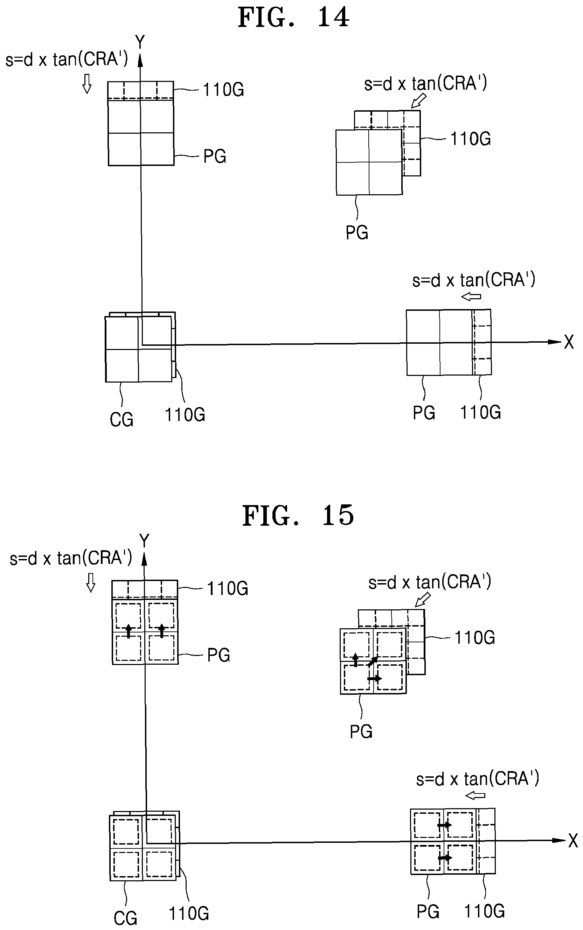

In the peripheral group PG, arrows and displacement indicated in the first pixel corresponding region 131, the second pixel corresponding region 132, and the fourth pixel corresponding region 134 are indicated based on the third pixel corresponding region 133. In the third pixel corresponding region 133, s indicates that the peripheral group PG is misaligned with facing pixel group 110G by s, unlike the central group CG. For the convenience of description, s is indicated in the third pixel corresponding region 133, but the first to fourth pixel corresponding regions 131, 132, 133, and 134 may be shifted in a certain direction by a certain distance with respect to the first to fourth pixels 111, 112, 113, and 114 facing thereof. s will be described later with reference to FIG. 14, and in FIG. 8, the relative positional relationship among the first to fourth pixel corresponding regions 131, 132, 133, and 134 in the peripheral group PG will be described.

The relative positional relationship may be different between the peripheral groups PG at different locations. For example, the relative positional relationship may be different between the peripheral groups PG at different locations as indicated by different r or φ. That is, in one peripheral group PG, relative positional relationship among the nanoposts of the first pixel corresponding region 131, the nanoposts of the second pixel corresponding region 132, the nanoposts of the third pixel corresponding region 133, and the nanoposts of the fourth pixel corresponding region 134 is different from the relative positional relationship among the nanoposts of the first pixel corresponding region 131, the nanoposts of the second pixel corresponding region 132, the nanoposts of the third pixel corresponding region 133, and the nanoposts of the fourth pixel corresponding region 134 in another peripheral group PG at different location.

According to an example embodiment, in one peripheral group PG, relative positional relationship among the nanoposts in the first to fourth pixel corresponding regions 131, 132, 133, and 134 may vary depending on the color of adjacent pixel corresponding region. For example, a distance between a center of the entire arrangement of nanoposts in the first pixel corresponding region 131 and a center of the entire arrangement of nanoposts in the second pixel corresponding region 132 may be different from a distance between the center of the entire arrangement of nanoposts in the first pixel corresponding region 131 and a center of the entire arrangement of nanoposts in the third pixel corresponding region 133. According to an example embodiment, in one peripheral group PG, at least two distances between the centers of the nanoposts arranged in adjacent pixel regions may be different from each other. According to an example embodiment, at least two of the distance between the center of the nanoposts of the first pixel corresponding region 131 and the center of the nanoposts of the second pixel corresponding region 132, the distance between the center of the nanoposts of the first pixel corresponding region 131 and the center of the nanoposts of the third pixel corresponding region 133, the distance between the center of the nanoposts of the second pixel corresponding region 132 and the center of the nanoposts of the fourth pixel corresponding region 134, and the distance between the center of the nanoposts of the third pixel corresponding region 133 and the center of the nanoposts of the fourth pixel corresponding region 134 may be different from each other. A degree of difference may vary depending on the position of the peripheral group PG.

The nanoposts of the first pixel corresponding region 131, the second pixel corresponding region 132, and the fourth pixel corresponding region 134 in the peripheral group PG are relatively shifted with respect to the third pixel corresponding region 133, as compared with the central group CG. In azimuth locations shown in the drawings, the nanoposts of the first pixel corresponding region 131, the second pixel corresponding region 132, and the fourth pixel corresponding region 134 in the peripheral group PG are relatively further shifted in the direction away from the third pixel corresponding region 133 when compared with the relative positional relationship among the first to fourth pixel corresponding regions 131, 132, 133, and 134 in the central group CG. For example, at a different azimuth location, the nanoposts of the first pixel corresponding region 131, the second pixel corresponding region 132, and the fourth pixel corresponding region 134 in the peripheral group PG are relatively further shifted in the direction close to the third pixel corresponding region 133 when compared with the relative positional relationship among the first to fourth pixel corresponding regions 131, 132, 133, and 134 in the central group CG. That is, the shifted distance and direction may be determined according to the CRA and the azimuth φ. That is, the shifted distance and distance may be determined by the distance r and the azimuth φ from the center C of the color separating lens array 130. Here, the distance r and the azimuth φ are described to be about the center of the peripheral group PG, but are not limited thereto. The distance r and the azimuth φ may be defined for each of the nanoposts in the peripheral group PG. A detailed value of the shifted distance of the nanoposts may be determined by the distance r and the azimuth φ representing the position of each nanopost, or may be determined by the distance r and the azimuth φ representing the center location of the corresponding peripheral group PG.

The nanoposts in the first pixel corresponding region 131, the second pixel corresponding region 132, and the fourth pixel corresponding region 134 may be further shifted in the direction away from the center C of the color separating lens array 130, with respect to the nanoposts of the third pixel corresponding region 133. As indicated by the arrows, the nanoposts of the second pixel corresponding region 132 in the peripheral group PG may be shifted in the direction away from the center C with respect to the nanoposts of the third pixel corresponding region 133 in the color separating lens array 130, the nanoposts of the first pixel corresponding region 131 may be shifted in the direction away from the axis (X-axis) that is parallel to the first direction while passing through the center C of the color separating lens array 130 with respect to the nanoposts of the third pixel corresponding region 133, and the nanoposts of the fourth pixel corresponding region 134 may be shifted in the direction away from the axis (Y-axis) that is parallel to the second direction while passing through the center C of the color separating lens array 130 with respect to the nanoposts of the third pixel corresponding region 133. The shifted distance may be in proportional to the distance r from the center C of the color separating lens array 130 of the corresponding peripheral group PG (or nanopost to be shifted), in other words, CRA.

The shift may be carried out in order to reduce the channel difference as described above. To do this, the nanoposts included in one pixel corresponding region are shifted together. For example, the nanoposts configured to operate as one lens covering the four photosensitive cells c1, c2, c3, and c4 shown in FIG. 3B are shifted together. The channel difference of a desired range may be set based on the signal value shown in the central group CG. For example, when a signal value from one of four photosensitive cells facing one of the first to fourth pixel corresponding regions 131, 132, 133, and 134 in the central group CG is 1, the shifted distance may be set so that the signal value from each of the four photosensitive cells facing one of the first to fourth pixel corresponding regions 131, 132, 133, and 134 in the peripheral group PG is in a range from 0.9 to 1.1, for example, from 0.92 to 1.08. Because the channel difference increases as the CRA increases, the shifted distance may be set so that the above condition may be satisfied in the peripheral group having a large CRA. For example, when a maximum value of the CRA of the incident angle on the color separating lens array 130 is CRA_max, the shifted distance may be set so that the channel difference in the desired range may be satisfied at the position where a value of CRA/CRA_max is 0.7 or greater, for example, 0.8 or greater, or 0.9 or greater.

In the peripheral group PG, the displacement of the nanoposts in the first pixel corresponding region 131 may be expressed by $(0, \Delta y)$, the displacement of the nanoposts in the second pixel corresponding region 132 may be expressed by $(\Delta x, \Delta y)$, and the displacement of the nanoposts in the fourth pixel corresponding region 134 may be expressed by $(\Delta x, 0)$. Here, the displacement is based on the relative positional relationship between the nanoposts of the first to fourth pixel corresponding regions 131, 132, 133, and 134 in the central group CG.

The displacement $(0, \Delta y)$ of the first pixel corresponding region 131 may satisfy following condition:

$$\Delta y = (gb0)*(CRA/CRA\_max) * \sin\varphi$$

Here, gb0 denotes a real number equal to or greater than 0 (zero), CRA_max denotes a CRA maximum value, CRA denotes a chief ray angle, and φ denotes an azimuth.

The displacement $(\Delta x, 0)$ of the fourth pixel corresponding region 134 may satisfy the following condition:

$$\Delta x = (gr0)*(CRA/CRA\_max) * \cos\varphi$$

Here, gr0 denotes a real number equal to or greater than 0 (zero), CRA_max denotes a CRA maximum value, CRA denotes a chief ray angle, and φ denotes an azimuth.

The displacement $(\Delta x, \Delta y)$ of the second pixel corresponding region 132 may satisfy following condition:

$$\Delta x = (b0)*(CRA/CRA\_max) * \cos\varphi$$

$$\Delta y = (b0)*(CRA/CRA\_max) * \sin\varphi$$

Here, b0 denotes a real number equal to or greater than 0, CRA_max denotes a CRA maximum value, CRA denotes a chief ray angle, and φ denotes an azimuth.

In the above equations, the constants of gb0, gr0, and b0 may be set to represent the desired channel difference at the position where the CRA has maximum value. The combination of the above values is not limited to one example, but may have various combinations.

The above equations are examples and may be changed. For example, the suggested displacements are linearly in proportional to the CRA, but are not limited thereto, and may be in proportional in another functional relationship, e.g., a non-linear relationship.

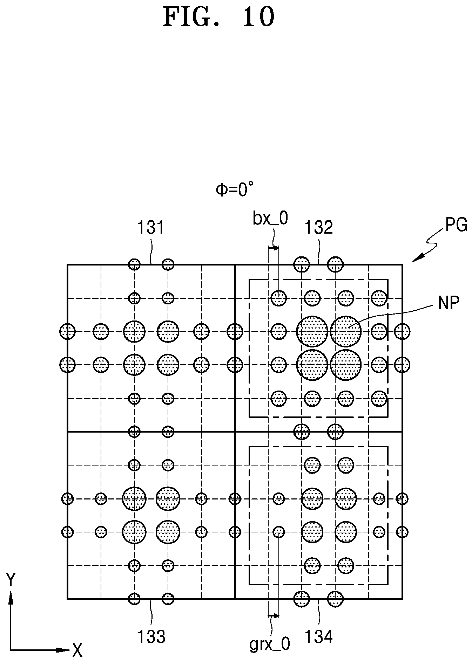

FIG. 9 is a plan view showing an example of nanoposts provided in the pixel corresponding region in the central group in the color separating lens array of the image sensor according to the example embodiment, and FIGS. 10 to 12 are plan views showing the nanoposts included in the pixel corresponding regions of the peripheral groups located at the azimuth of 0°, 45°, and 90°.

Referring to the drawings, as compared with the relative positional relationship between the nanoposts NP in the first to fourth pixel corresponding regions 131, 132, 133, and 134 in the central group CG shown in FIG. 9, the nanoposts in some pixel corresponding regions are shifted in the peripheral groups PG shown in FIGS. 10 to 12.

FIG. 10 shows the peripheral group PG at the location having the azimuth of 0°.

The nanoposts NP of the second pixel corresponding region 132, that is, the blue pixel corresponding region, are shifted by bx_0 in +X direction. bx_0 denotes (b0)*(CRA/CRA_max).

The nanoposts NP in the fourth pixel corresponding region 134, that is, the second green pixel corresponding region, are shifted by grx_0 in the +X direction, and the shifted distance grx_0 is (gr0)*(CRA/CRA_max).

According to an example embodiment, bx_0 and grx_0 are in proportional to the CRA. Therefore, when FIG. 10 is compared with FIG. 9 that shows the central group CG having the CRA of 0°, that is, when the relative positional relationship among the first to fourth pixel corresponding regions 131, 132, 133, and 134 in the peripheral group PG having the azimuth of 0° is compared with the relative positional relationship among the first to fourth pixel corresponding regions 131, 132, 133, and 134 in the central group CG, the nanoposts NP of the second pixel corresponding region 132 are further shifted in +X direction as compared with the central group CG, and the nanoposts NP in the fourth pixel corresponding region 134 are further shifted in +X direction as compared with the central group CG.

Also, in the peripheral group PG having the azimuth of 0°, when the relative positional relationship among the first to fourth pixel corresponding regions 131, 132, 133, and 134 in the peripheral group PG having a first CRA is compared with the relative positional relationship among the first to fourth pixel corresponding regions 131, 132, 133, and 134 in the peripheral group PG having a second CRA that is less than the first CRA, the second pixel corresponding region 132 and the fourth pixel corresponding region 134 may be described as follows.

In the peripheral groups PG having the azimuth of 0°, the nanoposts NP of the second pixel corresponding region 132 in the peripheral group PG having the first CRA may be further shifted in +X direction in the corresponding peripheral group PG, as compared with the relative positional relationship among the nanoposts NP of the second pixel corresponding region 132 in the peripheral group PG having the second CRA that is less than the first CRA.

In the peripheral groups PG having the azimuth of 0°, the nanoposts NP of the fourth pixel corresponding region 134 in the peripheral group PG having the first CRA may be further shifted in +X direction in the corresponding peripheral group PG, as compared with the relative positional relationship among the nanoposts NP of the fourth pixel corresponding region 134 in the peripheral group PG having the second CRA that is less than the first CRA.

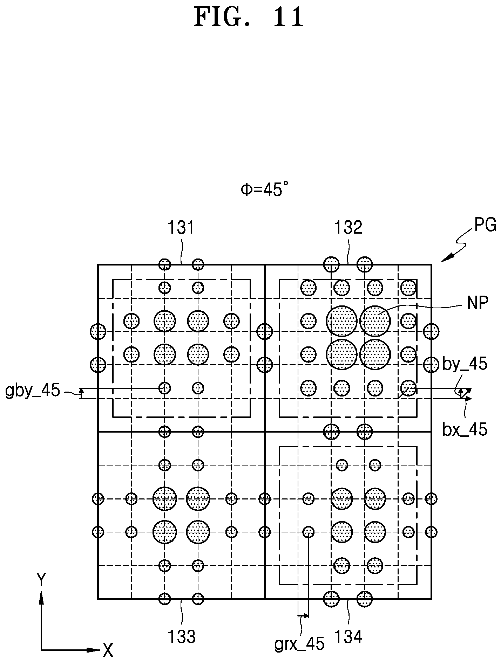

FIG. 11 shows the peripheral group PG at the location having the azimuth of 45°.

The nanoposts NP of the first pixel corresponding region 131, that is, the first green pixel corresponding region, are shifted by gby_45 in +Y direction, and gby_45 denotes (gb0)*(CRA/CRA_max)sin45°.

The nanoposts NP of the fourth pixel corresponding region 134, that is, the second green pixel corresponding region, are shifted by grx_45 in +X direction. grx_45 denotes (gr0)*(CRA/CRA_max)cos45°. The nanoposts NP of the second pixel corresponding region 132 are shifted by bx_45 in +X direction and by_45 in +Y direction. bx_45 is (b0)*(CRA/CRA_max)cos45°, and by_45 is (b0)*(CRA/CRA_max)sin45°.

According to an example embodiment, gby_45, grx_45, bx_45, by_45 are all in proportional to the CRA. Therefore, when FIG. 11 is compared with FIG. 9 that shows the central group CG having the CRA of 0°, that is, when the relative positional relationship among the first to fourth pixel corresponding regions 131, 132, 133, and 134 in the peripheral group PG having the azimuth 45 is compared with the relative positional relationship among the first to fourth pixel corresponding regions 131, 132, 133, and 134 in the central group CG, the first pixel corresponding region 131, the fourth pixel corresponding region 134, and the second pixel corresponding region 132 may be described as follows.

The nanoposts NP of the first pixel corresponding region 131 are further shifted in +Y direction as compared with the central group CG, the nanoposts NP of the fourth pixel corresponding region 134 are further shifted in +X direction as compared with the central group CG, and the nanoposts NP of the second pixel corresponding region 132 are further shifted in a direction of vector sum of +X direction and +Y direction.

Also, in the peripheral group PG having the azimuth of 45°, when the relative positional relationship among the first to fourth pixel corresponding regions 131, 132, 133, and 134 in the peripheral group PG having a first CRA is compared with the relative positional relationship among the first to fourth pixel corresponding regions 131, 132, 133, and 134 in the peripheral group PG having a second CRA that is less than the first CRA, the first pixel corresponding region 131, the second pixel corresponding region 132 may be described as follows with respect to the fourth pixel corresponding region 134.

In the peripheral groups PG having the azimuth of 45°, the nanoposts NP of the first pixel corresponding region 131 in the peripheral group PG having the first CRA may be further shifted in +Y direction in the corresponding peripheral group PG, as compared with the relative positional relationship among the nanoposts NP of the first pixel corresponding region 131 in the peripheral group PG having the second CRA that is less than the first CRA.

In the peripheral groups PG having the azimuth of 45°, the nanoposts NP of the fourth pixel corresponding region 134 in the peripheral group PG having the first CRA may be further shifted in +X direction in the corresponding peripheral group PG, as compared with the relative positional relationship among the nanoposts NP of the fourth pixel corresponding region 134 in the peripheral group PG having the second CRA that is less than the first CRA.

In the peripheral groups PG having the azimuth of 45°, the nanoposts NP of the second pixel corresponding region 132 in the peripheral group PG having the first CRA may be further shifted in the direction away from the central group CG in the corresponding peripheral group PG, as compared with the relative positional relationship among the nanoposts NP of the second pixel corresponding region 132 in the peripheral group PG having the second CRA that is less than the first CRA.

When comparing FIG. 10 with FIG. 11, grx_0 is greater than grx_45 at the same CRA location. That is, at the location having the same CRA, when the relative positional relationship among the first to fourth pixel corresponding regions 131, 132, 133, and 134 in the peripheral group PG having the azimuth of 0° is compared with the relative positional relationship among the first to fourth pixel corresponding regions 131, 132, 133, and 134 of the peripheral group PG having the azimuth of 45°, the fourth pixel corresponding region 134 may be described as follows.

From among the peripheral groups PG having the same CRA, the nanoposts NP in the fourth pixel corresponding region 134 of the peripheral group PG having the azimuth of 0° may be further shifted in +X direction in the corresponding peripheral group PG, as compared with the relative positional relationship among the nanoposts NP of the fourth pixel corresponding region 134 in the peripheral group PG having the azimuth of 45°.

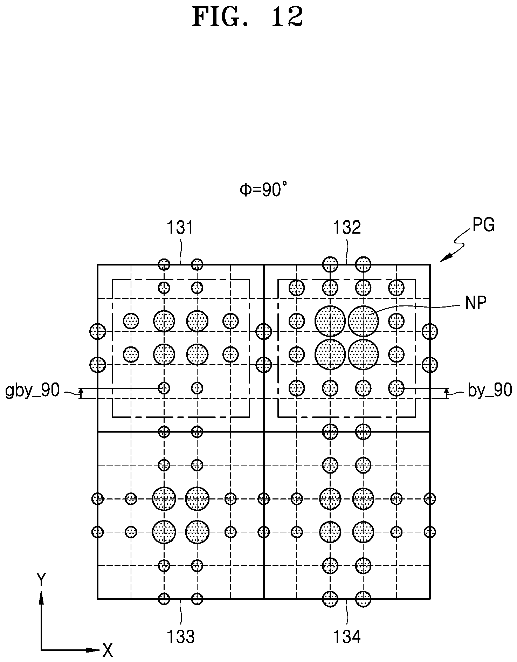

FIG. 12 shows the peripheral group PG at the location having the azimuth of 90°.

The nanoposts NP of the first pixel corresponding region 131 are shifted by gby_90 in +Y direction, and gby_90 is (gb0)*(CRA/CRA_max).

The nanoposts NP of the second pixel corresponding region 132 are shifted by by_90 in +Y direction, and by_90 is (b0)*(CRA/CRA_max).

According to an example embodiment, by_90 and gby_90 are in proportional to the CRA. Therefore, when FIG. 12 is compared with FIG. 9 that shows the central group CG having the CRA of 0°, that is, when the relative positional relationship among the first to fourth pixel corresponding regions 131, 132, 133, and 134 in the peripheral group PG having the azimuth of 90° is compared with the relative positional relationship among the first to fourth pixel corresponding regions 131, 132, 133, and 134 in the central group CG, the first pixel corresponding region 131 and the fourth pixel corresponding region 134 may be described as follows.

The nanoposts NP of the first pixel corresponding region 131 may be further shifted in +Y direction as compared with the central group CG, and the nanoposts NP of the second pixel corresponding region 132 may be further shifted in +Y direction as compared with the central group CG.

Also, in the peripheral group PG having the azimuth of 90°, when the relative positional relationship among the first to fourth pixel corresponding regions 131, 132, 133, and 134 in the peripheral group PG having a first CRA is compared with the relative positional relationship among the first to fourth pixel corresponding regions 131, 132, 133, and 134 in the peripheral group PG having a second CRA that is less than the first CRA, the first pixel corresponding region 131 and the second pixel corresponding region 132 may be described as follows.

In the peripheral groups PG having the azimuth of 90°, the nanoposts NP of the first pixel corresponding region 131 in the peripheral group PG having the first CRA may be further shifted in +Y direction in the corresponding peripheral group PG, as compared with the relative positional relationship among the nanoposts NP of the first pixel corresponding region 131 in the peripheral group PG having the second CRA that is less than the first CRA.

In the peripheral groups PG having the azimuth of 90°, the nanoposts NP of the second pixel corresponding region 132 in the peripheral group PG having the first CRA may be further shifted in +Y direction in the corresponding peripheral group PG, as compared with the relative positional relationship among the nanoposts NP of the first pixel corresponding region 131 in the peripheral group PG having the second CRA that is less than the first CRA.

Also, when comparing FIG. 12 with FIG. 11, gby_90 is greater than gby_45 at the same CRA position. That is, at the location having the same CRA, when the relative positional relationship among the first to fourth pixel corresponding regions 131, 132, 133, and 134 in the peripheral group PG having the azimuth of 90° is compared with the relative positional relationship among the first to fourth pixel corresponding regions 131, 132, 133, and 134 of the peripheral group PG having the azimuth of 45°, the first pixel corresponding region 131 may be described as follows.

From among the peripheral groups PG having the same CRA, the nanoposts NP in the first pixel corresponding region 131 of the peripheral group PG having the azimuth of 90° may be further shifted in +Y direction in the corresponding peripheral group PG, as compared with the relative positional relationship among the nanoposts NP of the first pixel corresponding region 131 in the peripheral group PG having the azimuth of 45°.

Also, when comparing FIG. 11 with FIGS. 10 and 12, by_45 and bx_45 are greater than 0. Therefore, at the location having the same CRA, when the relative positional relationship among the first to fourth pixel corresponding regions 131, 132, 133, and 134 in the peripheral group PG having the azimuth of 45° is compared with the relative positional relationship among the first to fourth pixel corresponding regions 131, 132, 133, and 134 of the peripheral group PG having the azimuth of 0° the relative positional relationship among the first to fourth pixel corresponding regions 131, 132, 133, and 134 of the peripheral group PG having the azimuth of 90°, the second pixel corresponding region 132 may be described as follows.

From among the peripheral groups PG having the same CRA, the nanoposts NP arranged in the second pixel corresponding region 132 of the peripheral group PG having the azimuth of 45° may be further shifted in +Y direction in the corresponding peripheral group PG, as compared with the relative positional relationship of the nanoposts NP arranged in the second pixel corresponding region 132 of the peripheral group PG having the azimuth of 0°, and may be further shifted in +X direction in the corresponding peripheral group PG, as compared with the relative positional relationship of the nanoposts NP arranged in the second pixel corresponding region 132 of the peripheral group PG having the azimuth of 90°.

In the description with reference to FIGS. 10 to 12, the movement of the nanoposts located at the boundaries between the pixel corresponding regions is not separately shown, but the nanoposts may be shifted with the displacement corresponding to the average displacement of the nanoposts in the adjacent pixel corresponding regions.

The descriptions with reference to FIGS. 10 to 12 are about an example of the first quadrant of the color separating lens array 130, that is, an example in which the azimuth is from 0° to 90°. Similar descriptions may be applied to other quadrants, except for the shifted direction. In the peripheral group PG located in the second quadrant and the third quadrant, the nanoposts NP of the fourth pixel corresponding region 134 are shifted in -X direction, and in the peripheral group PG located in the third quadrant and the fourth quadrant, the nanoposts NP of the first pixel corresponding region 131 are shifted in -Y direction. In the third quadrant, the nanoposts NP of the second pixel corresponding region 132 are shifted in -X and -Y directions, that is, in the direction away from the center C of the color separating lens array 130.

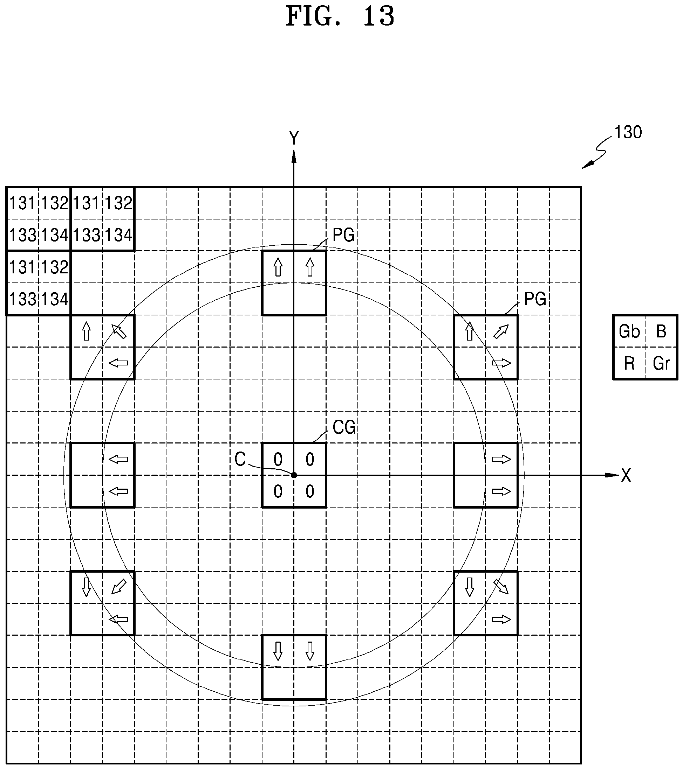

FIG. 13 is a plan view showing arrangement of nanoposts included in pixel corresponding regions of a plurality of peripheral groups located in another quadrant, as compared with the central group, in a color separating lens array of an image sensor according to an example embodiment.

Referring to FIG. 13, as described above, the relative position between the nanoposts in the adjacent pixel corresponding regions is different according to the location of the peripheral group PG, and the shifted degree of the nanoposts in the peripheral group PG is different as compared with the relative positions of the nanoposts in the central group CG.

The shifted type of the nanoposts may be considered to be substantially symmetrical with respect to the X-axis and Y-axis. When the first quadrant is between the azimuth of 0° to 90°, the second quadrant is between the azimuth of 90° to 180°, the third quadrant is between the azimuth of 180° to 270°, and the fourth quadrant is between the azimuth of 270° to 360°, the arrangement of the nanoposts in the first quadrant is substantially symmetrical with the arrangement of the nanoposts in the second quadrant with respect to the Y-axis and substantially symmetrical with the arrangement of the nanoposts in the fourth quadrant with respect to the X-axis. Also, the arrangement type of the nanoposts in the second quadrant is substantially symmetrical with the arrangement type of the nanoposts in the first quadrant based on the Y-axis and substantially symmetrical with the arrangement type of the nanoposts in the third quadrant based on the X-axis.

Here, 'substantially symmetrical' denotes that the symmetrical degree allows four quadrants may represent the same color separation performance although the arrangements are not completely symmetrical.

In case that the nanoposts in the first quadrant are moved by one pixel pitch in the X direction, the arrangement of the nanoposts in the first quadrant are symmetrical with the arrangement of nanoposts in the second quadrant with respect to that the Y-axis. Also, in case that the nanoposts in the first quadrant are moved by one pixel pitch in the Y direction, the nanoposts in the first quadrant are symmetrical with the nanoposts in the fourth quadrant with respect to the X-axis. Similarly, in case that the nanoposts in the third quadrant are moved by one pixel pitch in the X direction, the nanoposts in the third quadrant are symmetrical with the nanoposts in the fourth quadrant with respect to the Y-axis. Also, in case that the nanoposts in the third quadrant are moved by one pixel pitch in the Y direction, the nanoposts in the third quadrant are symmetrical with the nanoposts in the second quadrant with respect to the X-axis.

The shift of the nanoposts described above with reference to FIGS. 8 to 13 describes the relative positional relationship among the nanoposts of the first to fourth pixel corresponding regions 131, 132, 133, and 134 in each pixel corresponding group.

As briefly mentioned above, in the description with reference to FIG. 8, the plurality of pixel corresponding regions included in the image sensor 1000 of the example embodiment are not entirely aligned with facing pixels, and the pixel corresponding regions in the peripheral group PG, except for the central group CG, may be shifted from the facing pixels according to the positions thereof. For example, the alignment between the first to fourth pixels 111, 112, 113, and 114 and the first to fourth pixel corresponding regions 131, 132, 133, and 134 shown in FIGS. 4A and 4B is an example, and in another region of the color separating lens array 130, the pixels and the pixel corresponding regions may face each other while being shifted from each other.

FIG. 14 is a conceptual diagram for describing arrangement relationship between a unit pixel group included in a sensor substrate and a pixel corresponding group of a color separating lens array corresponding to the unit pixel group, in an image sensor according to an example embodiment.

Among the pixel corresponding groups, the central group CG is aligned with a facing unit pixel group 110G. That is, the first to fourth pixel corresponding regions 131, 132, 133, and 134 of the central group CG may be respectively aligned with the first to fourth pixels 111, 112, 113, and 114 in the unit pixel group 110G.

The peripheral group PG may be shifted from the facing unit pixel group 110G. The shifted direction is a direction toward the center of the color separating lens array 130, and the shifted distance is in proportional to the CRA. The shifted distance s may be represented by following equation.

According to an example embodiment, $s = d \times \tan(CRA')$

Here, d denotes a minimum straight distance between the lower surface of the color separating lens array 130 and the upper surface of the sensor substrate, and CRA' denotes an incident angle of light incident on the sensor substrate 110.

According to an example embodiment, CRA' may have following relation with CRA, that is, the incident angle of light that is incident on the color separating lens array 130.

According to an example embodiment, $CRA' = \sin^{-1}(n \times \sin CRA)$

Here, n denotes an effective refractive index of material layers arranged between the color separating lens array 130 and the sensor substrate 110.

Such shifting of the first to fourth pixel corresponding regions 131, 132, 133, and 134 included in the peripheral group PG is performed considering that the color separation efficiency of the color separating lens array 130 may be shown to be high within a certain angle range as described above. In the peripheral group PG having increased CRA, the first to fourth pixel corresponding regions 131, 132, 133, and 134 are shifted according to the direction of the incident angle of light, and then, the color separation may be effectively performed at the position having the large CRA.

The shift as the relative positional relationship between the adjacent pixel corresponding regions described above with reference to FIGS. 8 to 13 is related to a way of reducing the channel difference even at the position having the large CRA, and the shift shown in FIG. 14 is related to a way of maintaining the color separation efficiency even at the position having the large CRA. The above two ways may be implemented together in the image sensor 1000 according to the example embodiment, and are shown in FIG. 15 as an example.

FIG. 15 is a conceptual diagram for describing arrangement relationship between a unit pixel group included in a sensor substrate and nanoposts included in a pixel corresponding group of a color separating lens array corresponding to the unit pixel group, in an image sensor according to an example embodiment.

The first to fourth pixel corresponding regions 131, 132, 133, and 134 included in the peripheral group PG may be entirely shifted by a distance s toward the center C, with respect to the first to fourth pixels 111, 112, 113, and 114 included in the unit pixel group 110G facing the peripheral group PG. That is, the center of the entire arrangement of the nanoposts in the first pixel corresponding region 131 may be misaligned as much as the distance s, not being overlapped with the center of the first pixel 111. The center of the entire arrangement of the nanoposts in each of the second pixel corresponding region 132, the third pixel corresponding region 133, and the fourth pixel corresponding region 134 is also misaligned as much as the distance s with respect to the center of each of the second pixel 112, the third pixel 113, and the fourth pixel 114. Also, at the shifted position, some of the first to fourth pixel corresponding regions 131, 132, 133, and 134 in each peripheral group PG may be shifted with respect to one pixel corresponding region, that is, the relative positional relationship of the first to fourth pixel corresponding regions 131, 132, 133, and 134 may be differently adjusted for each peripheral group PG.

Here, 'adjusting of the relative positional relationship' denotes shifting of the nanoposts in some pixel corresponding regions of each peripheral group PG, except for the basic displacement, that is, the shifting of the entire nanoposts by the distance s toward the center C in each peripheral group PG.

The direction of the basic displacement s is a direction toward the center C, and the direction of adjusting the relative positional relationship is a direction away from the center C. The numerical range of the basic displacement may be greater than the numerical range of the relative positional relationship adjustment described above with reference to FIGS. 9 to 12. Therefore, when considering a vector sum of the adjusting of the relative positional relationship in each peripheral group PG and the basic displacement, the nanoposts in the peripheral group PG may be shifted in the direction toward the center C. That is, the center of the entire arrangement of the nanoposts in each pixel corresponding region of the peripheral group PG may be shifted toward the center C by s' (s'<s), not being overlapped with the center of the pixel corresponding thereto. In addition, as described above with reference to FIG. 14, s depends on the distance between the lower surface of the color separating lens array 130 and the upper surface of the sensor substrate 110 and the effective refractive index of the material provided between the lower surface of the color separating lens array 130 and the sensor substrate 110, and thus, the relationship between s' and the CRA may be various in each of the peripheral group PG.

For example, from among the peripheral groups PG having the same azimuth, the nanoposts of the second pixel corresponding region 132 in the peripheral group PG having the first CRA may be further shifted toward the center than the nanoposts of the second pixel corresponding region 132 in the peripheral group PG having the second CRA that is less than the first CRA, vice versa, or may be similar to the nanoposts of the second pixel corresponding region 132 in the peripheral group PG having the second CRA. The above relationship may depend upon the basic displacement s and the relative positional relationship adjusting displacement in the corresponding peripheral group PG.

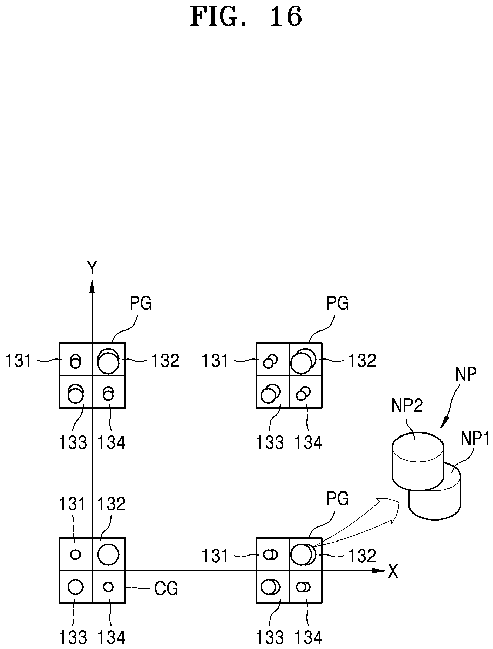

FIG. 16 is a conceptual diagram showing examples of shapes of nanoposts in a central group and a few peripheral groups, which may be applied to a color separating lens array of an image sensor according to an example embodiment.

The nanoposts NP may each have a stacked structure in which a first nanopost NP1 and a second nanopost NP2 are stacked. The second nanopost NP2 stacked on the first nanopost NP1 may be shifted toward the center C of the color separating lens array 130. The shifted degree may increase in proportional to the CRA. FIG. 16 shows an example in which one nanopost is shown in each of the first to fourth pixel corresponding regions 131, 132, 133, and 134, and is not limited thereto. For example, the nanoposts NP arranged as shown in FIG. 9 may each have multi-layered structure, and in the peripheral group PG, the nanoposts NP at the second layer may be shifted toward the center.

The shapes of the nanoposts NP are obtained by stacking the first nanoposts NP1 and the second nanoposts NP2 to be out of line with each other according to the CRA as described above with reference to FIG. 14, and are formed in order to maintain the color separation efficiency to be similar to the center portion even when the CRA increases. The nanoposts NP may be deformed to have three or more layers, rather than the dual-layered structure.

The example shapes of the nanoposts NP may be applied along with the relative shift among the pixel corresponding regions 131, 132, 133, and 134 in the peripheral group PG described above with reference to FIGS. 8 to 13. In other words, in addition to the relative shift shown in FIGS. 8 to 13, the arrangement of the nanoposts in the multi-layered structure to be out of line with each other may be reflected.

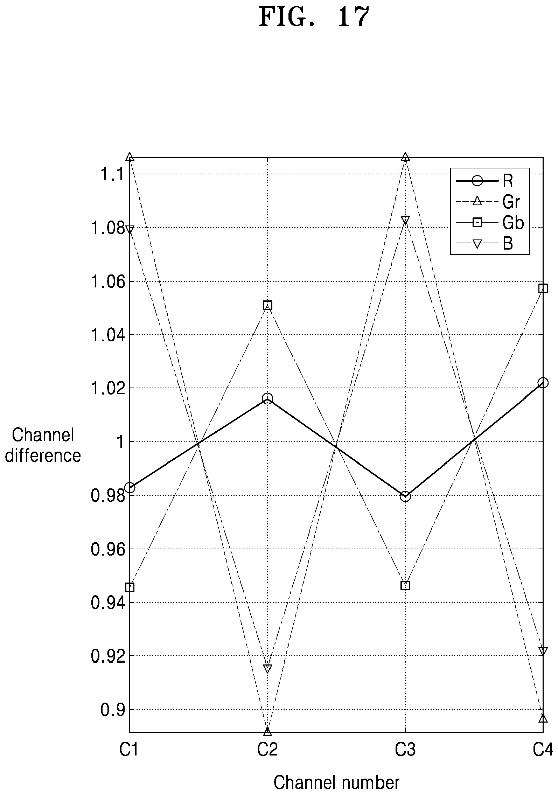

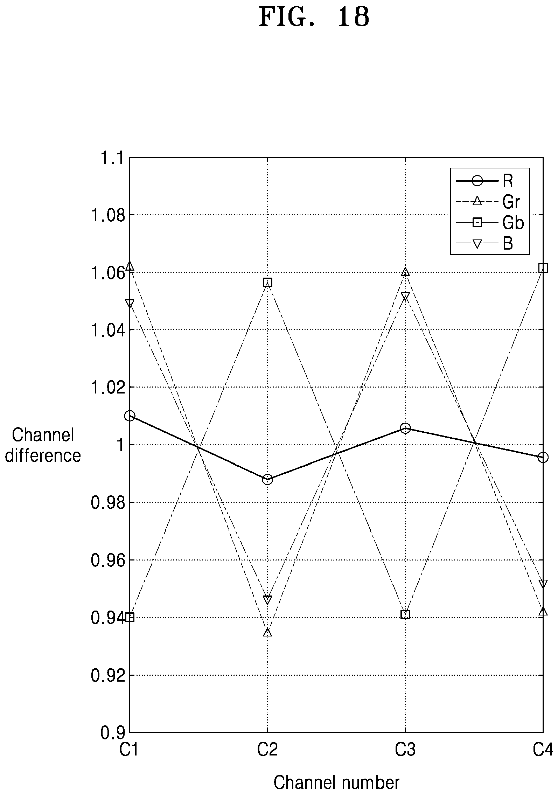

FIG. 17 is a graph showing an example of the channel difference represented in an image sensor according to the comparative example, and FIG. 18 is a graph showing an example of the channel difference represented in the image sensor according to the example embodiment.

The first, second, third, and fourth pixels are respectively a green pixel Gb, a blue pixel B, a red pixel R, and a green pixel Gr, and FIG. 18 shows an example in which the nanoposts in the second and fourth pixel corresponding regions are shifted by 60 nm in +X direction as compared with FIG. 17.

According to an example embodiment, a numerical value 1 indicated on the longitudinal axis is a reference value, for example, may be a signal value from one channel in the pixel corresponding to the central group. In FIG. 18, the channel differences in the green pixel Gr and the blue pixel B are improved as compared with FIG. 17. For example, the channel difference shown in FIG. 17 is about 0.89 to 0.11 and the channel difference shown in FIG. 18 is about 0.94 to about 1.06.

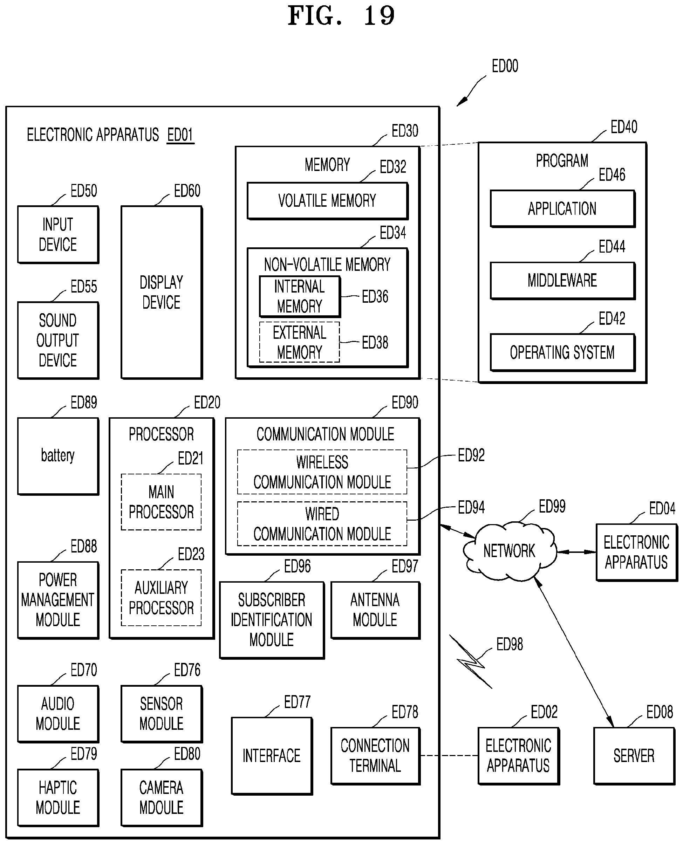

FIG. 19 is a block diagram of an electronic device including an image sensor according to one or more example embodiments. Referring to FIG. 19, in a network environment ED00, the electronic apparatus ED01 may communicate with another electronic apparatus ED02 via a first network ED98 (short-range wireless communication network, etc.), or may communicate with another electronic apparatus ED04 and/or a server ED08 via a second network ED99 (long-range wireless communication network, etc.) The electronic apparatus ED01 may communicate with the electronic apparatus ED04 via the server ED08. The electronic apparatus ED01 may include a processor ED20, a memory ED30, an input device ED50, a sound output device ED55, a display device ED60, an audio module ED70, a sensor module ED76, an interface ED77, a haptic module ED79, a camera module ED80, a power management module ED88, a battery ED89, a communication module ED90, a subscriber identification module ED96, and/or an antenna module ED97. In the electronic apparatus ED01, some (display device ED60, etc.) of the elements may be omitted or another element may be added. Some of the elements may be configured as one integrated circuit. For example, the sensor module ED76 (a fingerprint sensor, an iris sensor, an illuminance sensor, etc.) may be embedded and implemented in the display device ED60 (display, etc.)

The processor ED20 may control one or more elements (hardware, software elements, etc.) of the electronic apparatus ED01 connected to the processor ED20 by executing software (program ED40, etc.), and may perform various data processes or operations. As a part of the data processing or operations, the processor ED20 may load a command and/or data received from another element (sensor module ED76, communication module ED90, etc.) to a volatile memory ED32, may process the command and/or data stored in the volatile memory ED32, and may store result data in a non-volatile memory ED34. The processor ED20 may include a main processor ED21 (central processing unit, application processor, etc.) and an auxiliary processor ED23 (graphic processing unit, image signal processor, sensor hub processor, communication processor, etc.) that may be operated independently from or along with the main processor ED21. The auxiliary processor ED23 may use less power than that of the main processor ED21, and may perform specified functions.

The auxiliary processor ED23, on behalf of the main processor ED21 while the main processor ED21 is in an inactive state (sleep state) or along with the main processor ED21 while the main processor ED21 is in an active state (application executed state), may control functions and/or states related to some (display device ED60, sensor module ED76, communication module ED90, etc.) of the elements in the electronic apparatus ED01. The auxiliary processor ED23 (image signal processor, communication processor, etc.) may be implemented as a part of another element (camera module ED80, communication module ED90, etc.) that is functionally related thereto.

The memory ED30 may store various data required by the elements (processor ED20, sensor module ED76, etc.) of the electronic apparatus ED01. The data may include, for example, input data and/or output data about software (program ED40, etc.) and commands related thereto. The memory ED30 may include the volatile memory ED32 and/or the non-volatile memory ED34.

The program ED40 may be stored as software in the memory ED30, and may include an operation system ED42, middleware ED44, and/or an application ED46.

The input device ED50 may receive commands and/or data to be used in the elements (processor ED20, etc.) of the electronic apparatus ED01, from outside (user, etc.) of the electronic apparatus ED01. The input device ED50 may include a microphone, a mouse, a keyboard, and/or a digital pen (stylus pen).

The sound output device ED55 may output a sound signal to outside of the electronic apparatus ED01. The sound output device ED55 may include a speaker and/or a receiver. The speaker may be used for a general purpose such as multimedia reproduction or record play, and the receiver may be used to receive a call. The receiver may be coupled as a part of the speaker or may be implemented as an independent device.

The display device ED60 may provide visual information to outside of the electronic apparatus ED01. The display device ED60 may include a display, a hologram device, or a projector, and a control circuit for controlling the corresponding device. The display device ED60 may include a touch circuitry set to sense a touch, and/or a sensor circuit (pressure sensor, etc.) that is set to measure a strength of a force generated by the touch.

The audio module ED70 may convert sound into an electrical signal or vice versa. The audio module ED 70 may acquire sound through the input device ED50, or may output sound via the sound output device ED55 and/or a speaker and/or a headphone of another electronic apparatus (electronic apparatus ED02, etc.) connected directly or wirelessly to the electronic apparatus ED01.

The sensor module ED76 may sense an operating state (power, temperature, etc.) of the electronic apparatus ED01, or an outer environmental state (user state, etc.), and may generate an electrical signal and/or data value corresponding to the sensed state. The sensor module ED76 may include a gesture sensor, a gyro-sensor, a pressure sensor, a magnetic sensor, an acceleration sensor, a grip sensor, a proximity sensor, a color sensor, an infrared (IR) ray sensor, a vivo sensor, a temperature sensor, a humidity sensor, and/or an illuminance sensor.

The interface ED77 may support one or more designated protocols that may be used in order for the electronic apparatus ED01 to be directly or wirelessly connected to another electronic apparatus (electronic apparatus ED02, etc.) The interface ED77 may include a high-definition multimedia interface (HDMI), a universal serial bus (USB) interface, an SD card interface, and/or an audio interface.

The connection terminal ED78 may include a connector by which the electronic apparatus ED01 may be physically connected to another electronic apparatus (electronic apparatus ED02, etc.). The connection terminal ED78 may include an HDMI connector, a USB connector, an SD card connector, and/or an audio connector (headphone connector, etc.).

The haptic module ED79 may convert the electrical signal into a mechanical stimulation (vibration, motion, etc.) or an electric stimulation that the user may sense through a tactile or motion sensation. The haptic module ED79 may include a motor, a piezoelectric device, and/or an electric stimulus device.

The camera module ED80 may capture a still image and a video. The camera module ED80 may include a lens assembly including one or more lenses, the image sensor 1000 described above, image signal processors, and/or flashes. The lens assembly included in the camera module ED80 may collect light emitted from an object that is an object to be captured.

The power management module ED88 may manage the power supplied to the electronic apparatus ED01. The power management module ED88 may be implemented as a part of a power management integrated circuit (PMIC).

The battery ED89 may supply electric power to components of the electronic apparatus ED01. The battery ED89 may include a primary battery that is not rechargeable, a secondary battery that is rechargeable, and/or a fuel cell.

The communication module ED90 may support the establishment of a direct (wired) communication channel and/or a wireless communication channel between the electronic apparatus ED01 and another electronic apparatus (electronic apparatus ED02, electronic apparatus ED04, server ED08, etc.), and execution of communication through the established communication channel. The communication module ED90 may be operated independently from the processor ED20 (application processor, etc.), and may include one or more communication processors that support the direct communication and/or the wireless communication. The communication module ED90 may include a wireless communication module ED92 (cellular communication module, a short-range wireless communication module, a global navigation satellite system (GNSS) communication module) and/or a wired communication module ED94 (local area network (LAN) communication module, a power line communication module, etc.). From among the communication modules, a corresponding communication module may communicate with another electronic apparatus via a first network ED09 (short-range communication network such as Bluetooth, WiFi direct, or infrared data association (IrDA)) or a second network ED99 (long-range communication network such as a cellular network, Internet, or computer network (LAN, WAN, etc.)). Such above various kinds of communication modules may be integrated as one element (single chip, etc.) or may be implemented as a plurality of elements (a plurality of chips) separately from one another. The wireless communication module ED92 may identify and authenticate the electronic apparatus ED01 in a communication network such as the first network ED98 and/or the second network ED99 by using subscriber information (international mobile subscriber identifier (IMSI), etc.) stored in the subscriber identification module ED96.

The antenna module ED97 may transmit or receive the signal and/or power to/from outside (another electronic apparatus, etc.). An antenna may include a radiator formed as a conductive pattern formed on a substrate (PCB, etc.). The antenna module ED97 may include one or more antennas. When the antenna module ED97 includes a plurality of antennas, from among the plurality of antennas, an antenna that is suitable for the communication type used in the communication network such as the first network ED98 and/or the second network ED99 may be selected by the communication module ED90. The signal and/or the power may be transmitted between the communication module ED90 and another electronic apparatus via the selected antenna. Another component (RFIC, etc.) other than the antenna may be included as a part of the antenna module ED97.

Some of the elements may be connected to one another via the communication method among the peripheral devices (bus, general purpose input and output (GPIO), serial peripheral interface (SPI), mobile industry processor interface (MIPI), etc.) and may exchange signals (commands, data, etc.).

The command or data may be transmitted or received between the electronic apparatus ED01 and the external electronic apparatus ED04 via the server ED08 connected to the second network ED99. Other electronic apparatuses ED02 and ED04 may be the devices that are the same as or different kinds from the electronic apparatus ED01. All or some of the operations executed in the electronic apparatus ED01 may be executed in one or more devices among the other electronic apparatuses ED02, ED04, and ED08. For example, when the electronic apparatus ED01 has to perform a certain function or service, the electronic apparatus ED01 may request one or more other electronic apparatuses to perform some or entire function or service, instead of executing the function or service by itself. One or more electronic apparatuses receiving the request execute an additional function or service related to the request and may transfer a result of the execution to the electronic apparatus ED01. To do this, for example, a cloud computing, a distributed computing, or a client-server computing technique may be used.

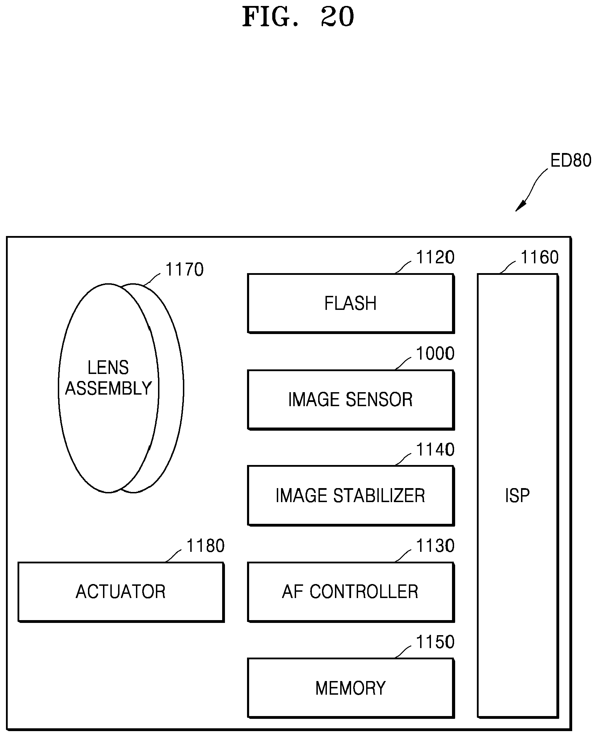

FIG. 20 is a block diagram showing an example of the camera module ED80 included in the electronic apparatus ED01 of FIG. 19. Referring to FIG. 20, the camera module ED80 may include a lens assembly 1170, a flash 1120, an image sensor 1000, an image stabilizer 1140, an AF controller 1130, a memory 1150 (buffer memory, etc.), an actuator 1180, and/or an image signal processor (ISP)1160.

The lens assembly 1170 may collect light emitted from an object that is to be captured. The lens assembly 1170 may include one or more optical lenses. The lens assembly 1170 may include a path switching member which switches the optical path toward the image sensor 1000. According to whether the path switching member is provided and the arrangement type with the optical lens, the camera module ED80 may have a vertical type or a folded type. The camera module ED80 may include a plurality of lens assemblies 1170, and in this case, the camera module ED80 may include a dual camera module, a 360-degree camera, or a spherical camera. Some of the plurality of lens assemblies 1170 may have the same lens properties (viewing angle, focal distance, auto-focus, F number, optical zoom, etc.) or different lens properties. The lens assembly 1170 may include a wide-angle lens or a telephoto lens.

The actuator 1180 may drive the lens assembly 1170. At least some of the otpical lens and the path switching member included in the lens assembly 1170 may be moved by the actuator 1180. The optical lens may be moved along the optical axis, and when the distance between adjacent lenses is adjusted by moving at least some of the optical lenses included in the lens assembly 1170, an optical zoom ratio may be adjusted.

The actuator 1180 may adjust the position of any one of the optical lenses in the lens assembly 1170 so that the image sensor 1000 may be located at the focal length of the lens assembly 1170. The actuator 1180 may drive the lens assembly 1170 according to an AF driving signal transferred from the AF controller 1130.

The flash 1120 may emit light that is used to strengthen the light emitted or reflected from the object. The flash 1120 may emit visible light or infrared-ray light. The flash 1120 may include one or more light-emitting diodes (red-green-blue (RGB) LED, white LED, infrared LED, ultraviolet LED, etc.), and/or a Xenon lamp. The image sensor 1000 may be the image sensor 1000 described above with reference to FIG. 1, or may be a variation thereof. The image sensor 1000 may obtain an image corresponding to a subject by converting the light emitted or reflected from the subject and transferred through the lens assembly 1170 into an electrical signal.

The image sensor 1000 includes the color separating lens array 130 described above, and each pixel may include a plurality of photosensitive cells forming a plurality of channels, for example, the plurality of photosensitive cells arranged in a 2x2 array. Some of the pixels may be used as AF pixels, and the image sensor 1000 may generate an AF driving signal from the signals from the plurality of channels in the AF pixels. From among the nanoposts in the color separating lens array included in the image sensor 1000, the arrangement type of the nanoposts of the periphery portion is adjusted so that the channel difference may be reduced, and thus, an accuracy of the AF driving may be improved.

The image stabilizer 1140, in response to a motion of the camera module ED80 or the electronic apparatus ED01 including the camera module ED80, moves one or more lenses included in the lens assembly 1170 or the image sensor 1000 in a certain direction or controls the operating characteristics of the image sensor 1000 (adjusting of a read-out timing, etc.) in order to compensate for a negative influence of the motion. The image stabilizer 1140 may sense the movement of the camera module ED80 or the electronic apparatus ED01 by using a gyro sensor or an acceleration sensor arranged in or out of the camera module ED80. The image stabilizer 1140 may be implemented as an optical type.

The AF controller 1130 may generate the AF driving signal from signal values sensed from the AF pixels in the image sensor 1000. The AF controller 1130 may control the actuator 1180 according to the AF driving signal.

The memory 1150 may store some or entire data of the image obtained through the image sensor 1000 for next image processing operation. For example, when a plurality of images are obtained at a high speed, obtained original data (Bayer-patterned data, high resolution data, etc.) is stored in the memory 1150, and a low resolution image is only displayed. Then, original data of a selected image (user selection, etc.) may be transferred to the image signal processor 1160. The memory 1150 may be integrated with the memory ED30 of the electronic apparatus ED01, or may include an additional memory that is operated independently.

The ISP 1160 may perform image treatment on the image obtained through the image sensor 1000 or the image data stored in the memory 1150. The image treatments may include a depth map generation, a three-dimensional modeling, a panorama generation, extraction of features, an image combination, and/or an image compensation (noise reduction, resolution adjustment, brightness adjustment, blurring, sharpening, softening, etc.). The image signal processor 1160 may perform controlling (exposure time control, read-out timing control, etc.) of the elements (image sensor 1000, etc.) included in the camera module ED80. The image processed by the image signal processor 1160 may be stored again in the memory 1150 for additional process, or may be provided to an external element of the camera module ED80 (e.g., the memory ED30, the display device ED60, the electronic apparatus ED02, the electronic apparatus ED04, the server ED08, etc.). The image signal processor 1160 may be integrated with the processor ED20, or may be configured as an additional processor that is independently operated from the processor ED20. When the image signal processor 1160 is configured as an additional processor separately from the processor ED20, the image processed by the image signal processor 1160 undergoes through an additional image treatment by the processor ED20 and then may be displayed on the display device ED60.

The AF controller 1130 may be integrated with the image signal processor 1160. The image signal processor 1160 may generate the AF signal by processing signals from the AF pixels of the image sensor 1000, and the AF controller 1130 may convert the AF signal into a driving signal of the actuator 1180 and transfer the signal to the actuator 1180.

The electronic apparatus ED01 may further include one or a plurality of camera modules having different properties or functions. The camera module may include elements similar to those of the camera module ED80 of FIG. 20, and the image sensor included in the camera module may be implemented as a charge coupled device (CCD) sensor and/or a complementary metal oxide semiconductor (CMOS) sensor and may include one or a plurality of sensors selected from the image sensors having different properties, such as an RGB sensor, a black and white (BW) sensor, an IR sensor, or a UV sensor. In this case, one of the plurality of camera modules ED80 may include a wide-angle camera and another camera module ED80 may include a telephoto camera. Similarly, one of the plurality of camera modules ED80 may include a front camera and another camera module ED80 may include a rear camera.

The image sensors according to the example embodiments may be applied to various electronic apparatuses.

The image sensor 1000 according to the example embodiments may be applied to a mobile phone or a smartphone, a tablet or a smart tablet, a digital camera or a camcorder, a laptop computer, or a television or a smart television. For example, the smartphone or the smart tablet may include a plurality of high-resolution cameras each including a high-resolution image sensor. Depth information of objects in an image may be extracted, out focusing of the image may be adjusted, or objects in the image may be automatically identified by using the high-resolution cameras.

Also, the image sensor 1000 may be applied to a smart refrigerator, a surveillance camera, a robot, a medical camera, etc. For example, the smart refrigerator may automatically recognize food in the refrigerator by using the image sensor, and may notify the user of an existence of a certain kind of food, kinds of food put into or taken out, etc. through a smartphone. Also, the surveillance camera may provide an ultra-high-resolution image and may allow the user to recognize an object or a person in the image even in dark environment by using high sensitivity. The robot may be input to a disaster or industrial site that a person may not directly access, to provide the user with high-resolution images. The medical camera may provide high-resolution images for diagnosis or surgery, and may dynamically adjust a field of view.

Also, the image sensor 1000 may be applied to a vehicle. The vehicle may include a plurality of vehicle cameras arranged on various locations, and each of the vehicle cameras may include the image sensor according to the example embodiment. The vehicle may provide a driver with various information about inside the vehicle or around the vehicle by using the plurality of vehicle cameras, and may automatically recognize an object or a person in the image to provide information required to the autonomous travel.

Because the color separating lens array included in the image sensor described above may separate the incident light by wavelengths and condense the separated light without absorbing or blocking the incident light, the light utilization efficiency of an image sensor may be improved.

Also, the nanoposts of the color separating lens array are designed considering the light that is incident on the periphery portion of the image sensor at an angle, and thus, the performance degradation according to the incident angle may be reduced and the quality of images obtained by the image sensor may be improved. For example, the nanoposts of the color separating lens array are configured to take in to account light that is incident on the periphery portion of the image sensor in a slant manner.

While the image sensor and the electronic apparatus including the image sensor have been particularly shown and described with reference to exemplary embodiments thereof, it will be understood by those of ordinary skill in the art that various changes in form and details may be made therein without departing from the scope as defined by the following claims. The example embodiments should be considered in descriptive sense only and not for purposes of limitation. Therefore, the scope of the disclosure is defined not by the detailed description of the disclosure but by the appended claims, and all differences within the scope will be construed as being included in the disclosure.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims and their equivalents.

## Claims

1. An image sensor comprising:

a sensor substrate comprising a plurality of pixel unit groups, each of the plurality of pixel unit groups comprising a first pixel, a second pixel, a third pixel, and a fourth pixel arranged in a Bayer pattern; and
a color separating lens array configured to separate incident light according to wavelengths and condense the light onto each of the first pixel, the second pixel, the third pixel and the fourth pixel,
wherein the color separating lens array comprises a plurality of pixel corresponding groups respectively corresponding to the plurality of unit pixel groups, each of the plurality of pixel corresponding groups comprising a first pixel corresponding region corresponding to the first pixel, a second pixel corresponding region corresponding to the second pixel, a third pixel corresponding region corresponding to the third pixel, and a fourth pixel corresponding region corresponding to the fourth pixel, and each of the first pixel corresponding region, the second pixel corresponding region, the third pixel corresponding region and the fourth pixel corresponding region comprising a plurality of nanoposts,
wherein the plurality of pixel corresponding groups comprising a central group located at a center of the color separating lens array and a plurality of peripheral groups located away from the center of the color separating lens array, and wherein relative positional relationships among the nanoposts in the first pixel corresponding region, the second pixel corresponding region, the third pixel corresponding region and the fourth pixel corresponding region in each of the plurality of peripheral groups are different from each other.

2. The image sensor of claim 1, wherein each of the first pixel, the second pixel, the third pixel and the fourth pixel comprises four photosensitive cells arranged in a 2x2 array.

3. The image sensor of claim 1 or 2, wherein the relative positional relationships among the nanoposts for each of the plurality of pixel corresponding groups is configured according to a chief ray angle and an azimuth that are defined according to a position of the peripheral group on the image sensor.

4. The image sensor of any preceding claim, wherein

the fourth pixel is adjacent to the third pixel in a first direction, the first pixel is adjacent to the third pixel in a second direction that is perpendicular to the first direction, the second pixel is adjacent to the third pixel in a diagonal direction, and
the third pixel is a red pixel, the first pixel and the fourth pixel are green pixels, and the second pixel is a blue pixel.

5. The image sensor of claim 4, wherein, based on the relative positional relationships between the nanoposts of the first pixel corresponding region, the second pixel corresponding region, the third pixel corresponding region and the fourth pixel corresponding region in the central group, one or more of the nanoposts in the first pixel corresponding region, the second pixel corresponding region, the third pixel corresponding region and the fourth pixel corresponding region are shifted in the peripheral group with respect to the central group.

6. The image sensor of claim 5,

wherein the one or more of the nanoposts of the first pixel corresponding region in the peripheral group are shifted in the second direction,
wherein a shifted displacement of the one or more of the nanoposts of the first pixel corresponding region is proportional to $(CRA/CRA\_max) * \sin\varphi$, and
wherein CRA_max denotes a maximum value of a chief ray angle of light incident on the color separating lens array, CRA denotes a chief ray angle at a position of the one or more shifted nanopost, and $\varphi$ denotes an azimuth at the position of the one or more shifted nanopost based on an axis that passes through the center of the color separating lens array and is in parallel with the first direction.

7. The image sensor of claim 5, wherein

the one or more nanoposts of the fourth pixel corresponding region in the peripheral group are shifted in the first direction,
wherein a shifted displacement of the fourth pixel corresponding region is proportional to $(CRA/CRA\_max) * \cos\varphi$,
where CRA_max denotes a maximum value of a chief ray angle of light incident on the color separating lens array, CRA denotes a chief ray angle at a position of the one or more shifted nanopost, and $\varphi$ denotes an azimuth at the position of the one or more shifted nanopost based on an axis that passes through the center of the color separating lens array and is in parallel with the first direction.

8. The image sensor of claim 5, wherein

the one or more nanoposts of the second pixel corresponding region in the peripheral group are shifted in the first direction and the second direction,
wherein a shifted displacement of the one or more nanoposts of the second color separating lens in the first direction is proportional to $(CRA/CRA\_max) * \cos\varphi$,
wherein a shifted displacement one or more nanoposts of the second color separating lens in the second direction is proportional to $(CRA/CRA\_max) * \sin\varphi$, and
wherein CRA_max denotes a maximum value of a chief ray angle of light incident on the color separating lens array, CRA denotes a chief ray angle at a position of the one or more shifted nanopost, and $\varphi$ denotes an azimuth at the position of the one or more shifted nanopost based on an axis that passes through the center of the color separating lens array and is in parallel with the first direction.

9. The image sensor of any of claims 5 to 8, wherein one or more nanoposts located at a boundary between different pixel corresponding regions from among the first pixel corresponding region, the second pixel corresponding region, the third pixel corresponding region and the fourth pixel corresponding region in the peripheral group are shifted by an average displacement of the nanoposts in adjacent pixel corresponding regions.

10. The image sensor of claim 4, wherein

the first direction is X direction and the second direction is Y direction,
the first pixel corresponding region is a first green pixel corresponding region, the second pixel corresponding region is a blue pixel corresponding region, the third pixel corresponding region is a red pixel corresponding region, and the fourth pixel corresponding region is a second green pixel corresponding region, and
wherein, in peripheral groups from among plurality of peripheral groups, having an identical chief ray angle (CRA), one or more nanoposts arranged in the first pixel corresponding region of a first peripheral group having an azimuth of 90° with respect to the central group in the first direction are shifted in the second direction as compared with one or more nanoposts arranged in the first pixel corresponding region of a second peripheral group having an azimuth of 45° based on the first direction.

11. The image sensor of claim 10, wherein in the peripheral groups having the identical CRA, one or more nanoposts arranged in the second green pixel corresponding region of a third peripheral group having an azimuth of 0° with respect to the central group in the X direction are shifted in +X direction as compared with one or more nanoposts arranged in the second green pixel corresponding region of a fourth peripheral group having an azimuth of 45° based on the +X direction.

12. The image sensor of claim 10, wherein in the peripheral groups having the identical CRA, one or more nanoposts arranged in the blue pixel corresponding region of a fifth peripheral group having an azimuth of 45° with respect to the central group based on the X direction are:

shifted in +X direction in the fifth peripheral group as compared with one or more nanoposts arranged in the blue pixel corresponding region of a sixth peripheral group having an azimuth of 90° based on the X direction, and
shifted in +Y direction in the fifth peripheral group as compared with one or more nanoposts arranged in the blue pixel corresponding region of a seventh peripheral group having an azimuth of 0° based on the X direction.

13. The image sensor of claim 10, wherein in the plurality of peripheral groups, one or more nanoposts arranged in the first green pixel corresponding region of an eighth peripheral group having an azimuth of 90° with respect to the central group based on the X direction and having a first CRA are shifted in +Y direction in the eight peripheral group, as compared with one or more nanoposts arranged in the first green pixel corresponding region of a ninth peripheral group having an azimuth of 90° based on the X direction and having a second CRA that is less than the first chief ray angle.

14. The image sensor of claim 13, wherein

in the plurality of peripheral groups, one or more nanoposts arranged in the first green pixel corresponding region of a tenth peripheral group having an azimuth of 0° with respect to the central group based on the X direction and having the first CRA are shifted in +X direction in the tenth peripheral group, as compared with one or more nanoposts arranged in the second green pixel corresponding region of a eleventh peripheral group having an azimuth of 0° based on the X direction and having the second CRA that is less than the first chief ray angle, and optionally wherein
in the plurality of peripheral groups, one or more nanoposts arranged in the blue pixel corresponding region of a twelfth peripheral group having an azimuth of 45° with respect to the central group based on the X direction and having the first CRA are shifted in a direction away from the central group in the corresponding peripheral group, as compared with one or more nanoposts arranged in the blue pixel corresponding region of a thirteenth peripheral group having an azimuth of 45° based on the X direction and having the second CRA that is less than the first CRA.

15. An electronic apparatus comprising:

a lens assembly comprising one or more lenses and configured to form an optical image of an object;
an image sensor according to any preceding claim configured to convert the optical image formed by the lens assembly into an electrical signal; and
a processor configured to process a signal generated by the image sensor.

# FIG. 1

1000

1100

PX

1020 — ROW DECODER

1010 — T/C

1030

OUTPUT CIRCUIT

# FIG. 2A

# FIG. 2B

# FIG. 3A

1100

| G | B | G | B | G | B |
|---|---|---|---|---|---|
| R | G | R | G | R | G |
| G | B | G | B | G | B |
| R | G | R | G | R | G |
| G | B | G | B | G | B |
| R | G | R | G | R | G |

Y
Z X

# FIG. 3B

# FIG. 3C

130

130G

| 131 | 132 | 131 | 132 | 131 | 132 |
| 133 | 134 | 133 | 134 | 133 | 134 |
| 131 | 132 | 131 | 132 | 131 | 132 |
| 133 | 134 | 133 | 134 | 133 | 134 |
| 131 | 132 | 131 | 132 | 131 | 132 |
| 133 | 134 | 133 | 134 | 133 | 134 |

Y

Z   X

# FIG. 4A

# FIG. 4B

# FIG. 5A

# FIG. 5B

GL1

134   133   134

132   131   132

134   133   134

114   113   114

112   111   112

114   113   114

Z   Y

X

# FIG. 5C

# FIG. 5D

# FIG. 5E

130

| 131 | 132 | 131 | 132 | 131 | 132 |
|-----|-----|-----|-----|-----|-----|
| 133 | 134 | 133 | 134 | 133 | 134 |
| 131 | 132 | 131 | 132 | 131 | 132 |
| 133 | 134 | 133 | 134 | 133 | 134 |
| 131 | 132 | 131 | 132 | 131 | 132 |
| 133 | 134 | 133 | 134 | 133 | 134 |

BL

Y

Z X

# FIG. 6A

# FIG. 6B

# FIG. 6C

# FIG. 6D

# FIG. 6E

# FIG. 7

# FIG. 8

# FIG. 9

# FIG. 10

# FIG. 11

$\Phi=45°$

# FIG. 12

$\Phi=90°$

# FIG. 13

# FIG. 14

s=d x tan(CRA')

110G

PG

s=d x tan(CRA')

110G

PG

s=d x tan(CRA')

X

PG    110G

CG    110G

# FIG. 15

s=d x tan(CRA')

110G

PG

s=d x tan(CRA')

110G

PG

s=d x tan(CRA')

X

PG    110G

CG    110G

# FIG. 16

# FIG. 17

# FIG. 18

# FIG. 19

ED00

ELECTRONIC APPARATUS ED01

ED50
INPUT DEVICE

ED55
SOUND OUTPUT DEVICE

ED60
DISPLAY DEVICE

ED30
MEMORY ED32
VOLATILE MEMORY

ED34
NON-VOLATILE MEMORY
INTERNAL MEMORY ED36
EXTERNAL MEMORY ED38

ED40
PROGRAM
ED46 APPLICATION
ED44 MIDDLEWARE
ED42 OPERATING SYSTEM

ED89
battery

ED20
PROCESSOR
ED21 MAIN PROCESSOR
ED23 AUXILIARY PROCESSOR

ED90
COMMUNICATION MODULE
ED92 WIRELESS COMMUNICATION MODULE
ED94 WIRED COMMUNICATION MODULE

ED88
POWER MANAGEMENT MODULE

ED96
SUBSCRIBER IDENTIFICATION MODULE

ED97
ANTENNA MODULE

ED99 NETWORK

ED04 ELECTRONIC APPARATUS

ED98

ED70
AUDIO MODULE

ED76
SENSOR MODULE

ED77
INTERFACE

ED78
CONNECTION TERMINAL

ED02
ELECTRONIC APPARATUS

ED08
SERVER

ED79
HAPTIC MODULE

ED80
CAMERA MDOULE

55

# FIG. 20

ED80

LENS ASSEMBLY — 1170

FLASH — 1120

IMAGE SENSOR — 1000

IMAGE STABILIZER — 1140

ACTUATOR — 1180

AF CONTROLLER — 1130

MEMORY — 1150

ISP — 1160

**EUROPEAN SEARCH REPORT**

Application Number

EP 23 19 4011

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/208822 A1 (YUN SEOKHO [KR] ET AL) 30 June 2022 (2022-06-30) | 1-5,15 | INV. H01L27/146 |
| A | * paragraphs [0174] - [0176], [0184]; figures 29A-29G, 30A-30C, 33 * ----- | 6-14 | |
| A | CN 114 447 006 A (SAMSUNG ELECTRONIC JOINT BASED CONSULTATION) 6 May 2022 (2022-05-06) * figures 9A-14F * ----- | 1-15 | |

TECHNICAL FIELDS SEARCHED (IPC)

H01L

The present search report has been drawn up for all claims

| Place of search | Date of completion of the search | Examiner |
|---|---|---|
| The Hague | 16 January 2024 | Cabrita, Ana |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
........................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 19 4011

This annex lists the patent family members relating to the patent documents cited in the above-mentioned European search report.
The members are as contained in the European Patent Office EDP file on
The European Patent Office is in no way liable for these particulars which are merely given for the purpose of information.

16-01-2024

| Patent document cited in search report | | Publication date | Patent family member(s) | | Publication date |
|---|---|---|---|---|---|
| US 2022208822 | A1 | 30-06-2022 | CN | 114695408 A | 01-07-2022 |
| | | | EP | 4024459 A1 | 06-07-2022 |
| | | | KR | 20220096967 A | 07-07-2022 |
| | | | US | 2022208822 A1 | 30-06-2022 |
| CN 114447006 | A | 06-05-2022 | CN | 114447006 A | 06-05-2022 |
| | | | EP | 3993046 A1 | 04-05-2022 |
| | | | JP | 2022074063 A | 17-05-2022 |
| | | | US | 2022141427 A1 | 05-05-2022 |

EPO FORM P0459

For more details about this annex : see Official Journal of the European Patent Office, No. 12/82